# EUROPÄISCHE PATENTSCHRIFT

(11) **EP 4 200 587 B1**
(45) Veröffentlichungstag und Bekanntmachung des Hinweises auf die Patenterteilung: **15.05.2024**
(21) Anmeldenummer: 21766433.3
(22) Anmeldetag: 19.08.2021
(51) Int. Cl.: G01M 5/00, G01M 11/08

(54) **VERFAHREN UND FLUGGERÄT ZUR ÜBERWACHUNG VON BETRIEBSZUSTÄNDEN UND ZUR ERMITTLUNG VON AUSFALLWAHRSCHEINLICHKEITEN VON STROMFÜHRENDEN LEITUNGSSYSTEMEN**
METHOD AND AIRCRAFT FOR MONITORING OPERATIONAL STATES AND FOR DETERMINING OUTAGE PROBABILITIES OF CURRENT-CARRYING LINE SYSTEMS
PROCÉDÉ ET APPAREIL VOLANT POUR SURVEILLER DES ÉTATS OPÉRATIONNELS ET DÉTERMINER DES PROBABILITÉS DE DÉFAILLANCE DE SYSTÈMES DE LIGNES ÉLECTRIQUES

(30) Priorität: 20.08.2020 DE 102020210622
(43) Veröffentlichungstag der Anmeldung: 28.06.2023
(73) Patentinhaber: WAGNER, Knut, 14770 Brandenburg an der Havel (DE)
(72) Erfinder: WAGNER, Knut, 14770 Brandenburg an der Havel (DE)
(74) Vertreter: Leske, Thomas
(86) Internationale Anmeldenummer: PCT/EP2021/073011
(87) Internationale Veröffentlichungsnummer: WO 2022/038220

(56) Entgegenhaltungen:
- US-A1- 2005 007 450
- US-A1- 2018 129 211
- US-A1- 2020 074 176

## Beschreibung

Die Erfindung betrifft ein Verfahren und ein Fluggerät zur Überwachung von Betriebszuständen und zur Ermittlung von Ausfallwahrscheinlichkeiten von stromführenden Leitungssystemen in Form von Energiefreileitungssystemen. Dieses Verfahren erfolgt aus der Luft mit einem Fluggerät in Form eines Drehflüglers, insbesondere eines Helikopters, mit welchem Masten, Leitungen und Umspannwerke einschließlich von deren Zubehör überwacht werden. Im Rahmen dieser Erfindung wird unter Helikopter im weitesten Sinne ein Drehflügler wie auch ein Fluggerät mit Senkrechtstartvermögen verstanden, mit dem ein Schwebeflug möglich ist.

Überwachungsverfahren und Fluggeräte zur Durchführung des Verfahrens und zur Ermittlung von physikalischen Eigenschaften sind bekannt.

Der Einsatz von Fluggeräten zur Durchführung von Überwachungen der Zustände von oberirdischen stromführenden Leitungssystemen, d. h. Energiefreileitungssysteme in Form von Stromtrassen, aus der Luft ist nicht nur relativ teuer. Fluggeräte weisen auch den Nachteil auf, dass für möglichst viele Messaufgaben die dafür nötige Zuladung der zahlreichen Messgeräte zur Durchführung der Vielzahl von Messungen jedoch durch die maximale Zuladung eines Fluggerätes beschränkt ist. Deshalb werden die Messaufgaben im Sinne eines Kompromisses auf das notwendige Minimum beschränkt. Bisher werden Überwachungen daher noch immer auch vom Boden aus durch Abschreiten der Leitungssysteme durch Personen oder durch Abfahren mit entsprechenden Fahrzeugen durchgeführt. Der Nachteil derartiger Systeme ist, dass derartig durchgeführte Inspektionen sehr viel Zeit benötigen. Elektrische Energie wird zunehmend über größere Entfernungen realisiert, so dass eine Inspektion durch Ablaufen aber selbst durch Einsatz von Bodenfahrzeugen nur in eingeschränktem Maße erfolgversprechend ist.

Üblicherweise erfolgt eine Überwachung von über- und auch unterirdischen stromführenden Trassen seit vielen Jahren durch Überfliegen derselben mit beispielsweise einem Helikopter. Neben dem Piloten, welcher eine vom Energieversorger vorgegebene Route abfliegt, welche gewöhnlich in Papierform dem Piloten zur Verfügung gestellt wird, ist ein für derartige Aufgaben ausgebildeter Mitarbeiter des die Energiefreileitungen betreibenden Energieversogers mit an Bord. Dabei werden visuelle Beobachtungen gemacht und entsprechend in vorhandene Unterlagen in der Regel manuell eingetragen, so dass später auf Basis des abgeflogenen Streckenplanes die gewonnenen Informationen entsprechend ausgewertet werden können, um Reparaturen oder sonstige Instandhaltungsmaßnahmen vornehmen zu können. Die visuell erkannten Fehler werden in diese Listen nach dem Flug eingetragen, welcher durchaus wegen der Länge der Energiefreileitungen bzw. der unterirdischen Stromtrassen auch in mehrere Etappen bei entsprechender Übernachtung an verschiedenen Orten erfolgen muss. Dabei werden beispielsweise Excel-Tabellen benutzt und jeweils als PDF-Datei abgespeichert. Ein so gewonnener sogenannter Hand-Over-Report wird dabei für den Kunden, in dem Fall der Energieversorger, zur Verfügung gestellt. Auch wenn zunehmend mehr Messtechnik an Bord eingesetzt werden kann, ist bei den bisher meistens durchgeführten Inspektionsflügen in dem benutzten Hubschrauber ein eigenständiger Rechner für weitere Aufgaben als die Abspeicherung von hauptsächlich visuell gewonnenen Daten nicht vorgesehen. Diese althergebrachten Systeme beziehungsweise Verfahren zur Überwachung der Stromtrassen und dabei insbesondere von Energiefreileitungen sind damit keinesfalls konform mit zunehmend höheren Anforderungen an die permanente und möglichst ausfallfreie Energieversorgung.

Nach Kenntnis des Anmelders ist es am weitesten verbreitet, für die Inspektion von Energiefreileitungen mittels eines Helikopters die abzufliegenden Strecken der Freileitung in Papierform dem Piloten zu übergeben, wobei die eigentliche Inspektion der Energiefreileitung während des Befliegens von entsprechend ausgebildeten, mitfliegenden Personen nur visuell erfolgt, allenfalls sind zusätzlich Thermalkameras im Einsatz. Die gewonnenen Daten werden von der zusätzlich mitfliegenden Person in ein Protokoll eingetragen und als Ergebnis der Befliegung dem Energieversorgungsunternehmen bereitgestellt, bei welchem entsprechende Auswertungen über zu unternehmende Reparaturen oder Wartungsaufgaben festgelegt werden. Es wird also weitestgehend auf Basis von manuell erstellten Protokollen in Papierform oder in Form von Kalkulationstabellen gearbeitet. Nach entsprechender Auswertung, beispielsweise in speziellen Meetings mit allen Beteiligten, werden in der Regel ergänzende Befliegungen vereinbart oder die durchzuführenden Reparatur- und Wartungsaufgaben festgelegt und entsprechend in die Wege geleitet. Analog wird bei unterirdischen Stromtrassen vorgegangen, wobei dabei eine visuelle Fehler- bzw. Defekterkennung eher eine untergeordnete Rolle spielt.

Die Inspektionen von Energieleitungssystemen sind von enormer Bedeutung, da schadensbedingte Ausfälle zur Unterbrechung der Stromversorgung in diversen Bereichen und damit Versorgungsengpässen führen können, die selbst in für Menschen lebensbedrohliche Zustände münden können, wie z. B. eine Unterbrechung der Stromversorgung in Krankenhäusern wie auch die Versorgung von heute in nahezu alle Bereiche des menschlichen Lebens eingreifende computerrealisierte Steuerungen von Vorrichtungen, Vorgängen und Abläufen. Prinzipiell muss die Stromversorgung Versorgungssicherheit von Bevölkerung und Wirtschaft gewährleisten. Hinzu kommt, dass die Unterbrechung von einer Stromversorgung in größeren Bereichen auch zu großen Problemen mit hohem Gefährdungspotential in den Kraftwerken wegen nicht erfolgender Abnahme des dort erzeugten Stromes führen kann. Es ist daher von enormer Wichtigkeit für das Aufrechterhalten der kompletten Infrastruktur der Volkswirtschaften, insbesondere für die strategisch wichtige Infrastruktur, derartige Versorgungssysteme zu 100% funktionieren zu lassen. Die Zuverlässigkeit und Verlässlichkeit der Überwachungssysteme spielt dabei im Rahmen der sogenannten Leistungssicherheit eine zentrale Rolle.

WO 2012/08 7 387 A2 beschreibt Wärmemessungen an Freileitungen beispielsweise von einem Fahrzeug oder Fluggerät aus, von welchem Laserscandaten aufgenommen werden, mittels welcher dreidimensionale Boden- und sonstige Strukturen einschließlich Abstandsmessungen der stromführenden Leitungen zur Vegetation durchgeführt werden. Mittels des Scannens erfolgt also eine Flurdarstellung im Umfeld einer Freileitung. Mittels einer Wärmebildkamera wird ausschließlich auf das Detektieren von Schäden auf dem Leiterseil abgestellt. Eine direkte Suche nach Schäden an dem Freileitungssystem, das selbstverständlich auch die Masten und Isolatoren beinhaltet, wie auch eine optische Bilddatengewinnung sind ebenso wenig beschrieben wie das Detektieren von Schäden eben an Masten und Isolatoren. Den Anforderungen für eine effiziente und umfassende Datengewinnung bei moderatem Aufwand für Befliegungen genügt dieses bekannte Verfahren nicht.

In US 4 818 990 wird ein Überwachungssystem unter Verwendung einer ferngesteuerten Drohne beschrieben. Mit dieser bekannten Drohne werden Überlandleitungen lediglich überflogen, wobei Flurvermessungen nicht durchgeführt werden. Das bei diesem bekannten System beschriebene Überfliegen der Überlandleitungen ermöglicht allenfalls nur stark eingeschränkt das Überwachen der Phasenseile. Gegebenenfalls müssten mehrere Überfliegungen mit jeweils unterschiedlicher Messtechnik durchgeführt werden, was einer effizienten Nutzung von Fluggeräten entgegensteht. Zwar ist in US 4 818 990 beschrieben, dass ein Flugsteuerrechner vorhanden ist, dass elektronische Sensoren die Zuladung für ein Fluggerät ermitteln und dass elektromagnetische und elektrostatische Feldsensoren, akustische Coronasensoren und Ultraviolettsensoren wie auch Infrarotwärmebilder und Videokameras eingesetzt werden können, sämtliche Informationen sind jedoch nicht ortsbezogen und nicht miteinander gekoppelt, sodass für eine hohe Zuverlässigkeit der Ergebnisse erforderliche große Datenvolumina nicht verarbeitet werden können. Die durchgeführten Flurvermessungen liefern eine Aussage über die Notwendigkeit, beispielsweise Pflanzenwuchs in Richtung der Leitungen zu unterbinden. Eine Zusammenfassung aller gewonnenen Daten und automatische Auswertung unter Ausgabe von Ausfallwahrscheinlichkeiten und erforderlichen Reparaturen und Beseitigungen von potentiellen Störstellen ist nicht beschrieben. Wesentlicher Nachteil des bekannten Systems ist, dass die gewonnenen Daten von der Drohne an ein mitfahrendes Bodenfahrzeug übertragen werden müssen, da die Zuladungskapazität für die Drohne sehr beschränkt ist.

In US 2020/0074176 A1 ist ein Verfahren zur Zustandsüberwachung von Energiefreileitungen beschrieben. Bei dem bekannten System sind zwar Kameras beschrieben, sie sind jedoch fest installiert und nicht schwenkbar. Die erforderliche Auflösung von unterhalb weniger Zentimeter erreichen sie nicht, welche für das Messen von beginnenden Oberflächenveränderungen notwendig wären. Weitere Sensorik für potentiell das System gefährdende Stellen ist nur zur Übersichtsdatengewinnung eingesetzt. Generell wird bei diesem bekannten System mit dem Fluggerät das Leitungssystem überflogen, ein Fliegen im Bereich der Phasenseile, d. h. ein Fliegen neben den Phasenseilen, ist weder beschrieben noch wegen der Ausrichtung der Kameras nur nach unten möglich. Vielmehr ist zum Erreichen einer verlässlichen Datenmenge und Datengenauigkeit bei notwendiger Unterstützung vom Boden, sei es mit einem Fahrzeug oder mit einer in der Nähe des Fluggerätes befindlichen Bodenstation, mindestens ein zweiter Flug in entgegengesetzter Richtung zur ersten Flug- und Aufnahmerichtung erforderlich. Zwar ist bei dem bekannten Verfahren angeregt, die gewonnenen Daten mittels geeigneter Software automatisiert auszuwerten, dazu werden aber die Daten notwendigerweise an ein mitfahrendes Fahrzeug, auf welchem die entsprechende Computertechnologie angeordnet ist, übertragen. Ein Helikopter könnte zwar dafür mit mehreren Kameras ausgerüstet sein, um beispielsweise einen Masten komplett bildmäßig zu erfassen. Dies wird aber als nachteilig herausgestellt wegen der begrenzten Zuladung der erforderlichen Hardware in einen Helikopter, erst recht aber in eine Drohne. Aus diesem Grunde wird vorgeschlagen, mit zumindest zwei Fahrzeugen zu arbeiten, einem Fahrzeug, das einen Laserscanner und eine Übersichtskamera aufweist, und ein zweites Fluggerät bzw. ein zweites Bodenfahrzeug, auf welchem bzw. in welchem eine Kamera für detaillierte Bildaufnahmen angeordnet ist. Nur wenn auf die Übersichtskamera verzichtet wird, ist es möglich, Laserscanning und eine Bilder von Details liefernde Kamera für die Bilddaten in einem Helikopter einzusetzen. Grundorientierung für das in US 2020/0074176 A1 beschriebene Verfahren ist die Verwendung von zwei Fahrzeugen, d. h. es wären im Falle eines Helikopters zumindest zwei Befliegungen eines Energiefreileitungssystems durchzuführen, nämlich ein Fluggerät, mittels welchem zunächst lediglich Übersichtsdaten gewonnen werden, und ein zweites Fluggerät, in welchem eine Kamera zur Bildaufnahme von Details angeordnet ist.

In US 7 298 869 B1 ist ein Datenerfassungssystem beschrieben, das vorzugsweise in einem Flugzeug eingesetzt wird. Mit dem Datenerfassungssystem sollen verborgene oder unterirdische Anomalien identifiziert und so gefiltert werden, dass ein dreidimensionales digitales Bild der überflogenen Oberfläche erzielt wird. Das System wird vom Piloten bedient, wobei Satellitennavigationssysteme nur für eine zeitliche und Positionsdatenzuordnung vorgenommen wird. Prinzipiell muss der Pilot in die Messdatenerfassung eingreifen. Überirdische Strukturen wie Energiefreileitungssysteme sind nicht beschrieben. Zwar wird für das bekannte System auf GPS-Daten zurückgegriffen, und es wird ein Laserscansystem für unterirdische Pipeline-Überwachungen eingesetzt, ein umfassendes, ein hohes Datenvolumen realisierendes und verarbeitendes Messwerteerfassungssystem ist bereits aus dem Grunde nicht möglich, weil als Flugzeug ein Ultraleicht-Flugzeug eingesetzt wird, bei welchem die Zuladung von Messtechnik von vorn herein hinsichtlich des Gewichtes stark begrenzt ist. Das bekannte Datenerfassungssystem dient der Erstellung von dreidimensionalen Informationen über die Topographie der Erdoberfläche, wobei das Vorhandensein von zwei Magnetometern auf unterirdisch angeordnete Leitungen weist. Prinzipiell muss das Fluggerät mit erd- oder wassergebundenen Fahrzeugen gekoppelt werden, um zuverlässige Informationen zu erhalten. Zur Erfassung von Anomalien von unterirdisch verlegten Leitungen wird deren Bereich bei konstanter Höhe (Meereshöhe) überflogen. Das Erfassen von Strukturen wie Energiefreileitungen, deren stromführenden Leitungen und daran befestigten bzw. damit verbundenen Elementen ist in diesem Dokument des Standes der Technik nicht beschrieben.

In US 2005/0007450 A1 sind wiederum ein System und ein Verfahren zum Gewinnen und Verarbeiten von physikalischen Daten beschrieben, welche mittels verschiedener Erfassungsgeräte gewonnen werden und auf einem Fahrzeug wie beispielsweise auch einem Helikopter montiert sein können. Das Datenerfassungssystem ist dafür vorgesehen, bodenbasierte Objekte einschließlich Stromleitungen beispielsweise mittels eines Helikopters abzubilden, welcher entlang der Energiefreileitungen fliegt und in welchem Datenerfassungsgeräte untergebracht sind. Unter Verwendung des GPS-Systems werden den gewonnenen Daten Ortskoordinaten zugeordnet. Zwar werden Defekte auch an Leitungen und daran angebrachten bzw. damit verbundenen Elementen gewonnen, die Qualität und Detailtreue der gewonnenen Messdaten reicht aber nicht aus, um detaillierte Instandhaltungs- oder Reparaturanweisungen mit genauer Ortsfestlegung zu ermitteln. Das bekannte Datenerfassungssystem arbeitet mit sogenannten NVOF-Sensoren, welche lediglich dazu benutzt werden, definierte Punkte mit engem Beobachtungswinkel aufzunehmen. Darüber hinaus werden sogenannte LIDAR/LADAR-Bildverarbeitungsgeräte verwendet, welche zur Entfernungsmessung benutzt werden, welche aber lediglich eine begrenzte Anzahl von Punkten pro erfasstem Quadratmeter ermöglichen, beispielsweise 25 Punkte pro Quadratmeter. Diese Systeme sind für einen hohen und dichten Datenstrom von beispielsweise 1.500 Punkte pro Quadratmeter erforderlich. In dem Maße ist auch das GPS-System nicht geeignet, die entsprechende Datendichte hinsichtlich einer Orts- und/oder Lagezuordnung zu gewährleisten. Ein Hinweis darauf, sämtliche erforderlichen Daten innerhalb einer einzigen Befliegung zu gewinnen, ist bei diesem bekannten System nicht erwähnt. Jeglicher Hinweis darauf, dass Inspektionsempfehlungen und/oder Reparaturempfehlungen identifiziert und ausgegeben werden, fehlt.

In US 2019/0364387 A1 ist eine Drohne beschrieben, mittels welcher Daten von Defekten an Boden-basierten Systemen, wie beispielsweise Stromleitungen, ermittelt werden. Nachteilig bei diesem bekannten System ist, dass der Einsatz von Drohnen zwingend vorgeschrieben ist, was von vorn herein die Zuladung einerseits und die Reichweite andererseits beschränkt. Nur mit großen und dichten Datenströmen, welche für eine exakte Ermittlung von Schäden an Energiefreileitungen einschließlich von örtlich genau festgelegten Reparaturempfehlungen und Instandhaltungsempfehlungen erforderlich sind, können die erforderlichen Informationen über den Zustand der Energiefreileitungssysteme ohne zusätzliches Personal oder dessen Einsatz erhalten werden. Die Reichweite der Drohne wird mit beispielsweise nur 20 km angegeben. Da sich Hochspannungsfreileitungen häufig über hunderte von Kilometern erstrecken, ist der Einsatz von Drohnen nur im begrenzten örtlichen Umfeld sinnvoll und möglich. Vor allen Dingen wegen der begrenzten Zuladung wird empfohlen, beispielsweise zu überwachende Stromtrassen mehrfach zu befliegen, um entsprechende genaue und verlässliche Daten zu erhalten. Des Weiteren erfordern die mit einer Drohne nur im begrenzten Umfang ermittelbaren Daten eine nachträgliche Auswertung durch eine menschliche Arbeitskraft. Ein weiteres relevantes Dokument aus dem Stand der Technik ist das Dokument US2018129211.

Und schließlich ist in DE 10 2015 013 550 A1 ein Steuerungssystem für autonom fliegende Drohnen beschrieben. Der beschriebene Gegenstand dieses bekannten Steuerungssystems ist darauf gerichtet, die bei der Befliegung anfallenden Daten hinsichtlich einer Auswertung unterstützend zu benutzen. Die beschränkt mögliche Datenmenge liefert dann auch nur eine erste Einschätzung über den Zustand eines inspizierten Objektes sowie nur eine erste Klassifizierung. Ein eine hohe Auflösung ermöglichendes Laserscansystem, eine Ausgabe von Inspektionsempfehlungen und Ausfallwahrscheinlichkeiten, eine Korrelation der Daten orts- und zeitbezogen werden nicht beschrieben, vielmehr wird angedeutet, dass mit Flugdrohnen mehrere Befliegungen erforderlich sind, abgesehen von der begrenzten Reichweite derartiger Flugdrohnen.

Demgegenüber besteht die Aufgabe der Erfindung darin, die wesentlichen Messaufgaben für eine umfassende Überwachung von Betriebszuständen von Energiefreileitungssystemen, d. h. Stromtrassen, mittels nur einer einzigen Befliegung mittels eines bemannten Fluggerätes vorzunehmen, welches mit einer dafür nötigen Messtechnik ausgerüstet ist, so dass mittels dieses Messsystems hochauflösende Bilder von möglichen Schadensorten bezüglich der Strukturen des Geländes wie auch der Strukturen der zu überwachenden Energiefreileitung kosteneffizient gewonnen werden können. Dabei sollen Bedingungen für die jeweilige Messung so ausgewählt werden, dass sich normalerweise ausschließende Flugbedingungen für unterschiedliche Messaufgaben aufeinander abstimmen lassen und mit nur einer Befliegung in beispielsweise einer für alle Messaufgaben optimalen Höhe bei einer Geschwindigkeit alle Messaufgaben zuverlässig erfüllt werden können. Außerdem soll das aufwendige Erstellen von Passpunkten für die Zuordnung von Laserscandaten, wie im Stand der Technik nötig, vermieden werden. Durch eine nur einmalige Befliegung sollen in erheblichem Maße Verbesserungen der Ökobilanz erreicht werden wie z. B. CO₂-Einsparungen und Reduzierung weiterer schädlicher Einflüsse auf die Umwelt.

Diese Aufgabe wird durch ein Verfahren mit den Merkmalen gemäß Anspruch 1 sowie durch ein Fluggerät mit den Merkmalen gemäß Anspruch 16 gelöst. Zweckmäßige Weiterbildungen sind in den jeweiligen abhängigen Ansprüchen definiert.

Das erfindungsgemäße Verfahren ist zur Überwachung von Betriebszuständen, Leitungsstruktur, Leitungssicherheit und zur Ermittlung von Ausfallwahrscheinlichkeiten von Energiefreileitungssystemen, d. h. von oberirdischen Stromtrassen, vorgesehen. Unter Leitungsstruktur wird hier die bautechnische Ausführung der zu überwachenden Systeme hinsichtlich z. B. Seile, kunststoffummantelte Kabel, Masten, Isolatoren, Traversen, Transformatoren, Umspannwerke, Sicherungssysteme, Markierungen usw. verstanden. Die Überwachung erfolgt aus der Luft mit einem Fluggerät. Das zur Durchführung des Verfahrens eingesetzte Fluggerät in Form eines Helikopters weist eine Sensorik, welche physikalische Eigenschaften darstellende Daten der zu überwachenden Systeme, d. h. Energiefreileitungssysteme, erfasst, zumindest eine hochauflösende Digitalkamera für Bilddaten der und um die Energiefreileitungssysteme herum vorhandenen Vegetation und Bebauung und mobilen Strukturen wie beispielsweise Baugeräte und einen hochauflösenden Laserscanner für eine Erfassung von Daten zu den Umgebungsbedingungen der Energiefreileitungssysteme auf. Unter hochauflösend soll hier ein System mit im Bereich von ca. 100 bis 1.500 Pixel/m² verstanden werden. Dies stellt eine umfassende Ausrüstung des die Überwachung von Betriebszuständen durchführenden Fluggerätes dar, weil insoweit nicht nur Schäden an den zu überwachenden Systemen, sondern auch beginnende Verschlechterungen von Zuständen an den Leitungen, Isolatoren oder anderen Teilen der zu überwachenden Systeme präventiv ermittelt, örtlich konkret und genau zugeordnet werden können. Darüber hinaus ist es möglich, Umgebungsbedingungen mit einzubeziehen, welche auch zu einem Ausfall der Energieversorgung führen können, wenn beispielsweise Baum- oder Sträucherwuchs in den Bereich der stromführenden Leitungen gelangt oder wenn beispielsweise Schäden an den die energieführenden Leitungen tragenden Masten aufgetreten sind, wie beispielsweise auch korrosionsbedingte beginnende Schäden. Die dafür gewonnenen Daten werden in eine Verarbeitungseinheit eingegeben und dort mit in Datenbanken abgelegten Wachstumsmodellen der Vegetation verglichen und für die Ausgabe von Reparatur- und Instandhaltungsempfehlungen ebenfalls berücksichtigt.

Um eine entsprechende Zuordnung der mit den verschiedenen Datenerfassungssystemen gewonnenen Daten vorzunehmen, sind die vorzugsweise auch Lagesensoren umfassende Sensorik, die Digitalkamera und der Laserscanner miteinander und auch mit Satellitennavigationssystemen, ausgenommen GPS, gekoppelt. Dadurch lassen sich eine genaue Zuordnung und genaue Lokalisierungen von vorhandenen oder beginnenden Schäden an den zu überwachenden Systemen ermitteln, wodurch entsprechende Reparatur- und/oder Instandhaltungsempfehlungen beispielsweise an den Energieversoger ausgebbar werden, ohne dass zuvor manuell bestimmte Daten in Listen eingetragen werden müssen. Die erfassten Daten können also orts- wie auch zeitbezogen einander zugeordnet und miteinander korreliert werden. Erfindungsgemäß ermittelt das Fluggerät auf Basis eines vorgegebenen Flugprofils in nur einer einzigen Befliegung des Energiefreileitungssystems sämtliche mit der vorgesehenen Messtechnik erfassbaren und benötigten Daten, welche erforderlich sind, um Instandhaltungs- und/oder Reparaturempfehlungen für einzelne Elemente, Abschnitte oder Bereiche der zu überwachenden Systeme detailgetreu auszugeben. Dafür ist eine hohe Datendichte vorgesehen und erforderlich. Die ermittelten Daten werden der Verarbeitungseinheit zugeführt, in welcher auf Basis eines Vergleiches mit beispielsweise Soll-Zuständen der zu überwachenden Systeme, wie z. B. von Wachstumsmodellen der Vegetation, welche in den Datenbanken gespeichert sind, notwendige Reparaturen und/oder Instandhaltungen, Empfehlungen wie auch Ausfallwahrscheinlichkeiten bei beginnenden Schäden ermittelt und an eine Ausgabeeinheit ausgegeben werden. Die Ausgabeeinheit kann vorzugsweise eine elektronische Anzeigeeinrichtung sein.

Vorzugsweise ist die Sensorik so ausgebildet, dass auch thermische Messungen wie Ultraviolett- und Infrarotmessungen mittels Thermalkameras, Thermalsensoren und/oder Thermalscanner durchgeführt werden können. Mit diesen Messungen ist es beispielsweise möglich, Defekte an stromführenden Teilen festzustellen, welche noch nicht zu einem Totalausfall, aber bereits zu einer Verschlechterung der physikalischen, stromführenden Eigenschaften geführt haben.

Vorzugsweise werden die in der Verarbeitungseinheit ermittelten Reparatur- und/oder Instandhaltungsempfehlungen und/oder Ausfallwahrscheinlichkeiten und/oder Sicherheitsempfehlungen, welche als Funktion der ermittelten Daten in der Datenbank abgelegt werden, in diese Datenbank eingegeben und für nachfolgende Vergleiche mit herangezogen, sodass durch den laufenden Betrieb sozusagen ein selbstlernendes System vorhanden ist.

Vorzugsweise weist die hochauflösende Digitalkamera 25 - 350 Megapixel Mindestauflösung und einen Bildsensor von mindestens 24x36 mm oder zumindest einen Mittelformat- oder Vollformatsensor auf. Um hochgenaue Daten mittels der Digitalkamera zu gewinnen, weist diese hochauflösende Digitalkamera eine harmonierende doppelte mechanische oder elektronische oder mechanisch-elektronisch gekoppelte Bildstabilisierung jeweils in der Kamera und im Objektiv auf. Damit können selbst bei unruhigem Flug mittels der Digitalkamera hochauflösende und detailliert auswertbare Fotos in das Auswertesystem übertragen werden. Vorzugsweise ist die Sensorik ebenfalls stabilisierend befestigt.

Der wesentliche Vorteil der Erfindung besteht vor allen Dingen darin, dass die im Stand der Technik vorhandenen Mehrfachbefliegungen zu einem einzigen Flug, d. h. einer einzigen Befliegung, miteinander vereint werden und dass die eingesetzte Technik zur Datenermittlung zusammengeführt und miteinander gekoppelt werden kann. Das bei bekannten Befliegungen eingesetzte visuelle Inspektionsverfahren wird durch die Entwicklung eines entsprechenden Flugprofils gemäß der Erfindung automatisiert. Mittels eines an Bord befindlichen Rechners, in welchem die aus den jeweiligen Messsystemen gewonnenen Daten miteinander verknüpft werden, können die Daten von ansonsten erforderlichen drei unterschiedlichen Befliegungen bei der tatsächlich nur einzigen Befliegung entsprechend ausgewertet werden. Die Auswertung der gewonnenen Daten, welche in der Datenbank gespeichert sind, schafft die Grundlage einer entsprechenden Auswertung, Bewertung und Beschreibung des für eine Reparatur oder Instandhaltung durchzuführenden Arbeitsprozesses beziehungsweise den Charakter der kontinuierlichen Wartungsmaßnahmen an den Freileitungen einerseits und bildet andererseits auch die Grundlage dafür, dass die durchgeführten Maßnahmen überwacht werden dahingehend, ob das ausgegebene Überwachungsprogramm beziehungsweise die ausgegebenen Instandhaltungs- oder Reparaturempfehlungen auch vollumfänglich durchgeführt worden sind. Auch insofern ist es wichtig, dass die durch die Befliegung gewonnen Daten wieder in das System eingepflegt werden, damit die Aufstellung von Reparatur- und Inspektionsempfehlungen der zur Reparatur erforderlichen Arbeitsprozesse detailliert angegeben sowie deren Ausführungen überprüft werden können.

Dadurch, dass die verschiedenen Inspektions- und Vermessungsaufgaben so zusammengeführt sind, dass sie in einer einzigen Befliegung vollumfänglich alle erforderlichen Daten bzw. Informationen liefern, wird ein gegenüber den bisherigen bekannten Verfahren, bei denen mehrere Befliegungen mit gegebenenfalls mehreren Fluggeräten erforderlich sind, eine deutliche Effizienzsteigerung erreicht. Vorzugsweise befinden sich an Bord des Fluggerätes, d. h. des Helikopters, beispielsweise für die Überwachung der während der Befliegung vorgenommenen Messungen eine entsprechend geschulte Fachkraft des Energieversorgers sowie eine Fachkraft zum Betreiben beziehungsweise Überwachen beziehungsweise Justieren und Fokussieren der Mess- und Aufnahmeeinrichtungen, d. h. des Sensorsystems, der Kameras und des hochauflösenden Laserscansystems (hochauflösendes LIDAR-System).

Die Überwachungssysteme für die Sensorik und das hochauflösende LIDAR-System sind vorzugsweise in der Kabine des Helikopters installiert. Zusätzlich sind ein Arbeitsplatz für die geschulte Fachkraft mit entsprechendem Arbeitstisch, die Computertechnik und die entweder automatisch oder auch handgeführte, vorzugsweise spiegellose Digitalkamera installiert.

Als eine wesentliche Grundvoraussetzung für sehr detailgetreue und eine hohe Anzahl von Informationsdaten enthaltene Aufnahmen durch die Kamera weist diese eine Auflösung von mindestens 25 bis maximal 350 Megapixel auf. Entscheidend für die Qualität der Aufnahme von Fehlern, Mängeln oder diversen, vom Energieversorger zu überwachenden Ereignissen ist aber die Ausstattung der Digitalkamera mit harmonierender doppelter Bildstabilisierung sowohl für die Kamera als auch für das Objektiv, und zwar mechanisch oder elektrisch oder elektromechanisch. Vorzugsweise weist die Digitalkamera eine Autofokussierung (AF) von < 0,11 Sekunden im Phasen-AF-Modus auf. Als Mindesteigenschaften weist diese Digitalkamera vorzugsweise einen Sensor mit mindestens 24x36 mm oder zumindest einen Mittelformat- oder Vollformatsensor auf. Zusätzlich weist die Kamera vorzugsweise eine WLAN-, Bluetooth oder NFC-Konnektivität-Schnittstelle auf. Dies ist je nach Einsatzort und Einbindung der Digitalkamera in das gesamte System der Messung für die gesamte Überwachung erforderlich. Die auf Basis der Messungen und der gewonnenen Daten erzielten Reparatur- und/oder Instandhaltungsempfehlungen werden detailliert ausgegeben, sodass beispielsweise für ein zu reparierendes Bauelement sogar der Arbeitsaufwand oder der Aufwand für die Instandhaltung genauestens definiert sind. Nach erfolgter Reparatur muss natürlich eine Nachkontrolle der tatsächlich ausgeführten Arbeiten an den Leitungssystemen vorgenommen werden. Das kann in herkömmlicher Weise durch gemeinsame Arbeitsbesprechungen mit dem Auftraggeber durchgeführt werden. Selbstverständlich kann das auch über entsprechende Datenabgleiche von zuvor ermittelter Schadenssituation und nach erfolgter Reparatur mit der tatsächlich vorhandenen Situation vorgenommen werden.

Häufig ist es auch erforderlich, insbesondere bei Energiefreileitungen, Stromschwankungen zu überwachen. Diese werden in die Gesamtdatenermittlung miteinbezogen und dienen ebenfalls der korrekten Einschätzung des Zustandes der Energiefreileitung. Auch diese Daten werden in der einzigen Befliegung gesammelt und aufgezeichnet und zu den übrigen Daten hinzugefügt und mit diesen entsprechend korreliert. Insbesondere trifft das zu für Schäden, welche einen unmittelbaren Einfluss auf eine Schwankung der Energieversorgung beziehungsweise des Stromflusses in einer jeweiligen Leitung haben.

Vorzugsweise kann bei dem Verfahren gemäß der Erfindung entweder eine Datenspeicherung komplett in dem zusätzlich an Bord befindlichen Computer erfolgen, oder es erfolgt eine Datenübertragung an eine Bodenstation oder an den Energieversorger selbst, und zwar vorzugsweise als Live-Übertragung mittels Satellitentelefon oder Mobilfunk. Sofern eine Datenübertragung an den Energieversorger oder Auftraggeber erfolgt, schließt diese vorzugsweise auch sämtliche erkannte Fehler oder Mängel mit entsprechenden Positionsdaten und Bilddaten in verknüpfter Weise ein, wobei vorzugsweise in der Verarbeitungseinheit ein Ranking hinsichtlich der Schwere eines Ereignisses enthalten ist. Dadurch erhält der Energieversorger unmittelbar, vorzugsweise an seinem Arbeitsplatz in seinem Unternehmen, direkte Informationen, welche Reparaturen wo und in welchem Aufwand mit welcher Manpower und Technik durchgeführt werden müssen, und zwar zweckmäßigerweise bevor ein Ausfall der Stromversorgung eintritt und/oder die Leitungssicherheit gefährdet ist. Vor allen Dingen das prophylaktische Beseitigen von sich abzeichnenden Schäden gemäß der Erfindung sichert eine zuverlässige Stromversorgung.

Vorzugsweise sind der Laserscanner, die Kamera beziehungsweise die Kameras und die Sensorik mit einer Universalvermessungsantenne gekoppelt, mittels welcher die zusammengesetzten Signale des Satellitennavigationssystems empfangen werden. Daran schließt sich ein Aufspalten der zusammengesetzten Signale in für einen jeweiligen Verarbeitungsprozess erforderliche Signaldaten an. Beispielsweise kann ein entsprechendes Satellitennavigationssignal unter anderem in ein sogenanntes L1- und L2-Signal oder in die erforderliche Signalaufspaltung aufgeteilt oder aus der vorhandenen Signalzusammensetzung gewonnen werden. Die normale Übertragung erfolgt dann als L1- Signal, während der für L2 vorgesehene Kanal als weitestgehend militärisch genutzter Übertragungsbereich aber ebenfalls mit entsprechender Zulassung und Vereinbarung in die Datengewinnung und Übertragung einbezogen werden kann. Wichtig für eine umfassende Datenerfassung und Verarbeitung der miteinander gekoppelten Daten ist, dass sämtliche Sensorik, das Laserscansystem wie auch die Kamera beziehungsweise Kameras dieselben Daten einer einzelnen Vermessungsantenne nutzen. Sofern ein einziges Behältnis für Sensorik, für Laserscansystem und Kameras genutzt wird, ist gewährleistet, dass alle drei Basissysteme die gleiche Trägheitsnavigationseinheit oder Lagesensoreinheit nutzen, welche kontinuierlich mit den Satellitensignalen im Computersystem korrespondiert. Die installierte Software steuert gleichzeitig im freien Modus die komplette Sensorik zur vollständigen Erfassung sämtlicher Mängel, Fehler und Ereignisse. Sie reguliert auch selbstständig nach, um eine stets höchstmögliche Messgenauigkeit zu garantieren.

Für besonders hohe Anforderungen der Bilddaten können Spezialkameras eingesetzt werden, welche einen übergroßen Sensor aufweisen, welcher aus mehreren zu einer Einheit zusammengefassten Mittelbild- oder Vollbildsensoren besteht.

Aus Gründen einer hohen Genauigkeit der gewonnenen Daten erfasst der hochauflösende Laserscanner die Daten im 360° Vollkreis in der Vertikalen rundum und erzeugt so eine hochauflösende 3D-Abbildung der stromführenden oder stoffführenden Infrastruktur mit einer Genauigkeit im Millimeterbereich. Auch diese Daten sind mit der Sensorik und den Kameras gekoppelt. Vorzugsweise werden die Bilddaten mit vier Digitalkameras erzeugt, welche am Fluggerät entsprechend so angebracht sind, dass Bilddaten in Flugrichtung schräg nach vorne, nach hinten und je einmal nach unten in Richtung auf den Boden aufgenommen werden können. Durch die Unterstützung durch die Digitalkameras werden Genauigkeiten bezüglich der Datenauflösung zur Bestimmung der tatsächlichen Abstände beziehungsweise Mindestabstände von beispielsweise Vegetation, Gebäuden, Aufschüttungen, anderen kreuzenden Freileitungen, Geländestrukturen, Darstellung der Beseilung der Freileitung, Veränderungen in der strukturellen Integrität der gesamten Architektur einer Freileitung inklusive von Umspannwerken beziehungsweise von Unterwerken beziehungsweise von stromerzeugenden oder spannungsumwandelnder Infrastruktur mit einer Genauigkeit von bis zu 0,7 cm pro Pixel erzielt.

Zur Datenerfassung für die Überwachung der Betriebszustände der Energiefreileitungssysteme fliegt das Fluggerät vorzugsweise mit einer Fluggeschwindigkeit im Bereich von 0 bis 60 km/h. Damit wird deutlich, dass es für unterschiedliche Überwachungsaufgaben Überlappungsbereiche gibt, innerhalb derer gegebenenfalls beide Aufgaben gleichzeitig erfüllt werden können. Ein wesentlicher Vorteil der Erfindung besteht unter anderem darin, dass entsprechend der gewählten Fluggeschwindigkeit für die zu überwachenden Systeme alle Mess- und Datenerfassungsaufgaben mit ein und derselben Fluggeschwindigkeit bei ein und derselben Befliegung gewonnen und entsprechend noch vor Ort im Helikopter oder gegebenenfalls auch in einem Rechenzentrum am Boden verarbeitet werden können. Natürlich kann die Fluggeschwindigkeit je nach benötigten Parametern variiert werden, und zwar in dem jeweils angegebenen Bereich. Die Fluggeschwindigkeit kann auch während der jeweiligen Befliegung beziehungsweise Inspektion zum Zweck einer näheren visuellen Inspektion durch die mitfliegende Person, d. h. dem geschulten Fachpersonal, und auch beispielsweise zur genaueren Detektion von Infrarot-, Thermal- und Corona-Auffälligkeiten geändert werden. Eine variable Fluggeschwindigkeit und einen teils erforderlichen Wechsel der zu beobachtenden Seite mit dem Fluggerät ist für sich verändernde Überwachungsbedingungen nötig und kann mit dem System ohne Weiteres realisiert werden, ohne dass weitere Befliegungen erforderlich wären.

Vorzugsweise fliegt das Fluggerät in Höhe der Energiefreileitung und dabei seitlich von deren Verlaufsrichtung in einem Abstand von 1 bis 50 m. Dies hat den Vorteil, dass recht nahe an den zu inspizierenden Systemen geflogen werden und damit die Datengenauigkeit weiter erhöht werden kann. Unter Beachtung der Regelungen zur Arbeit an oder in der Nähe von Freileitungen und stromverteilender und spannungswandelnder Infrastruktur beträgt der einzuhaltende Mindestabstand bei Mittelspannung 1 m, bei Hochspannung (>60 bis 200 kV) und Höchstspannung (>200 kV) meist mindestens 5 m.

Durch das permanente Aufzeichnen der Laserdaten und der selbstständigen Zuordnung der Datenreihenfolge ohne Verschiebung beziehungsweise ohne einen Datenversatz kann während des Fluges mit allen eingeschalteten Systemen und auch der visuell inspizierenden Fachkraft an Bord die Position an der zu überwachenden Energiefreileitung beliebig gewechselt werden, so dass Fehler, Mängel und entsprechende Zustände an den Leitungen beziehungsweise der gesamten Struktur der Leitungen nicht nur eindeutig festgestellt, sondern auch lokal eindeutig zugeordnet werden können. Dadurch ist das erfindungsgemäße Verfahren extrem variabel. Das das Verfahren realisierende Fluggerät, d. h. der Helikopter, muss nicht umgebaut werden, und sämtliche Messaufgaben, welche relevant sind für eine mögliche Reparatur oder eine Instandhaltung des zu überwachenden Systems, können, ohne dass der Helikopter umgebaut werden muss, durchgeführt werden.

Vorzugsweise weist das Fluggerät, vor allen Dingen in dem Fall, dass beispielsweise Fundamente von Masten nach Betriebszuständen und Ausfallswahrscheinlichkeiten inspiziert werden sollen, zusätzlich ein Radarsystem auf, welches in analoger Weise mit den anderen Mess- und Überwachungssystemen zur umfassenden und lokal eindeutig zuordnenden Auswertung abgestimmt und daten- bzw. signaltechnisch verbunden ist.

Vorzugsweise ist in den zur Durchführung des Verfahrens verwendeten Helikopter eine Messapparatur integriert, an welche eine weitere Sensorik angeschlossen ist zur Detektierung von Störungen im elektromagnetischen Feld bewirkenden Fehlern und/oder Defekten an den stromführenden Energiefreileitungssystemen. Die Sensorik für die stromführenden Leitungen speist also die Messapparatur mit den die Schwankungen im elektromagnetischen Feld charakterisierenden Störungen.

Vorzugsweise wird dafür ein selektives Strahlungsmessgerät (selective radiation meter) verwendet, um diese die Störungen charakterisierenden Schwankungen der elektromagnetischen Felder zu messen.

Vorzugsweise werden die Fehler und/oder Defekte mit Thermal-, IR-, Corona- oder Tageslichtsensoren oder Thermalscannern gemessen, wobei weiter vorzugsweise die Störungen und/oder Defekte an den Energiefreileitungssystemen als Störungen oder Änderungen im elektromagnetischen Feld mittels Antennen oder Antennenbündel erfasst und auch aufgezeichnet werden. Dabei wird ein Störsignal mittels der Antennen oder Antennenbündel automatisch in horizontaler und/oder vertikaler Richtung verfolgt.

Weiter vorzugsweise können die Störungen oder Änderungen im elektromagnetischen Feld, welche letztlich Defekte oder Fehler am Leitungssystem als Ursache haben, mit der Messapparatur hörbar gemacht und auf einem bildgebenden Element auch sichtbar gemacht werden. Es ist also möglich, dass erfasste Störungen direkt auf entsprechenden bildgebenden Elementen dargestellt werden, in einer Recheneinheit entsprechend aufbereitet werden und in ein Messprotokoll übertragbar sind, aus dem die Störungen nicht nur bezeichnet, sondern auch mit einer entsprechenden Zuordnung des Ortes ihres Auftretens und damit einer rascheren Behebung dieser Störungen den ein solches Messprotokoll auswertenden, verantwortlichen Mitarbeitern zur Verfügung gestellt werden kann.

Es geht also letztlich darum, die zusätzliche Sensorik, welche die Messapparatur speist, in das Fluggerät zu integrieren, um zusätzliche Fehlerquellen zu erfassen und um die Genauigkeit der Erkennung von Fehlern an Stromleitungen im visuell nicht sichtbaren Spektrum der gemessenen Wellenlängen der Signale zu erhöhen.

Überall dort, wo Elektrizität erzeugt, transportiert und genutzt wird, entstehen an den stromführenden Teilen bzw. um diese herum elektrische und magnetische Felder. Je höher die Stromstärke und die Spannung und je kleiner der Abstand des Messgerätes bzw. der Sensorik von den stromführenden Elementen ist, desto größer sind die entsprechenden Feldstärken. Die größten bzw. stärksten Belastungen treten im Bereich der Stromversorgung in unmittelbarer Nähe von Transformatorenstationen bzw. Umspannwerken sowie bei Mittel-, Hoch- und Höchstspannungsleitungen auf. Wenn es um die Messung von elektromagnetischen bzw. elektrischen und magnetischen Feldern geht, so erfahren diese im Betrieb der stromführenden Anlagen Schwankungen, wenn Qualitätsverschlechterungen, Defekte oder gar Störstellen an den Anlagen vorhanden sind.

Mit der eingesetzten Messtechnik werden auch unter Berücksichtigung der Frequenz die übertragene Wechselspannung und die durch die Leitung geleiteten Strommengen gemessen. Die Ermittlung dieser Messdaten dient der Bestimmung von Fehlern bzw. Mängeln der Stromtransportanlagen, welche letztlich zu Verringerungen ihrer Wirkungsgrade und zusätzlichen Verlusten führen. Es ist möglich, die Störungen bzw. Fehler durch UV-Kameras (Corona) und/oder IR-Kameras sichtbar zu machen. Damit werden diese Störungen aus dem nicht sichtbaren Bereich im sichtbaren Bereich visuell dargestellt und können so dokumentiert werden. Es ist mit entsprechenden verarbeitungsgerechten Einheiten auch möglich, diese Schwankungen der elektromagnetischen Felder hörbar zu machen. Die Intensität eines gemessenen Signals verringert sich mit zunehmendem Abstand zu Stromleitungen, d. h. den stromführenden Leiterseilen, wobei die Messsignale außerdem verschiedenartig verzerrt, gedämpft, abgeschwächt, aber unter bestimmten Bedingungen durchaus auch verstärkt sein können.

Auf Basis des grundlegenden physikalischen Prinzips gilt, dass die elektrische Feldstärke mit zunehmendem Abstand von den stromführenden Leitungen abnimmt. So ist beispielsweise die Feldstärke in einer Entfernung von bis zu 40 m zur Leitung messbar und lokalisierbar, und zwar mit einer Feldstärke von 10 Mikrotesla, und bei einer Entfernung bis 20 m von den stromführenden Leitungen hat das Magnetfeld eine Stärke von 10 bis 100 Mikrotesla. Natürlich sind elektrische Felder mit einer Feldstärke von mehreren tausend Volt/Meter deutlich leichter und intensiver bezüglich der Messsignale messbar, was sogar für im Erdboden verlegte Stromleitungen für die Ermittlung von Schadstellen gilt, wobei bezüglich der Messung vorzugsweise eine frequenzselektive Messung vorgenommen wird.

Gute Messergebnisse erreicht man beispielsweise auch dadurch, dass im Fluggerät beispielsweise ein selektives Strahlungsmessgerät (selective radiation meter) vorzugsweise in Kombination mit einem Thermalscanner, mit einer Thermal-, IR-, Corona- und/oder Tageslichtsensorik angeordnet ist. Damit können Fehlerquellen sehr genau bestimmt werden, zum Beispiel für Verbinder, Klemmstellen, Schäden an den leitungsführenden Seilen, Leiterseildurchgänge an Isolatoraufhängungen. Selbst in Erdungs- und Lichtwellenleitern an den äußeren Punkten wie z. B. Traversenspitzen bzw. Mastspitzen ist ein Messen bzw. ein Ermitteln der Schwankungen der elektromagnetischen Wellen zur Auffindung von Fehlern möglich. Zur Erfassung von derartigen Störungen des elektromagnetischen Feldes dienen Antennen oder Antennenbündel, welche vorzugsweise als Richtantennen ausgebildet sind und während des Inspektionsfluges optimal auf die zu untersuchenden stromführenden Leitungen gerichtet sind und dabei insbesondere die Störungen daran aufzuzeichnen und einer an Bord befindlichen Recheneinheit im Fluggerät zuführen. Die Richtcharakteristik der Antenne oder der Antennenbündel erlaubt dann eine zielgenaue Identifizierung der Störung und damit die Bestimmung der tatsächlichen Schadstelle, einschließlich der dort vorhandenen Fehlerquelle, beispielsweise eines Bauteils der Stromleitung.

Vorzugsweise sind die Antennen mit automatischer Richtungsfindung versehen, sodass eine Verfolgung des Störsignals in horizontaler wie auch in vertikaler Richtung möglich ist. Dadurch wird ein Abriss der Peilung während des Inspektionsfluges verhindert. Weiter vorzugsweise ist eine Kupplung mit einem GNSS (Global Navigation Satellite System)-Signal vorgesehen, welche die Zuordnung der Himmelsrichtung bei der Peilung, der Zeitinformationen und der Koordinaten für die spätere Auswertung der Daten sowie die Zuordnung der weiteren erzeugten Daten aus dem Einsatz der Sensorik und/oder aus visueller Inspektion ermöglicht. Die die jeweiligen Störungen reflektierenden Signale werden orts- und höhengenau bezüglich des Layouts der Stromleitungstrasse abgespeichert. Die Signale dienen auch der Unterstützung der durch die UV-Kamera (Corona-Kamera) sichtbar gemachten Schäden bzw. Fehler an den stromführenden Leitungen bzw. deren Bauteilen, sodass es damit nahezu ausgeschlossen ist bzw. erheblich reduziert werden kann, dass Fehlinterpretation eines im UV-Bereich gemessenen Schadens erfolgen. Die Messapparatur erfasst vorzugsweise an Defekten oder losen Bauteilen dort vorhandene Schäden, indem die Störfrequenz, was durch Knistern oder Rauschen deutlich wird, erfasst wird. Zusätzlich, wenn die schadhafte Stelle in der Stromleitung beispielsweise erhöhte Widerstände und damit in Verbindung Wärme freigibt, kann vorzugsweise die IR-Thermalsensorik diese schadhaften Stellen sichtbar machen und eine entsprechende Störfrequenzquelle auf oder an der Stromleitung bestätigen. Damit ist ein sogenanntes Back-up für die erfassten Störungen möglich.

Gleichermaßen können im Erdboden befindliche Starkstromleitungen, d. h. unterirdische Stromtrassen, mit diesen vorzugsweise im Fluggerät angeordneten Messsystemen bzw. der dort vorhandenen Messapparatur überprüft werden. Defekte oder beschädigte Leitungen von im Erdboden verlegten Starkstromleitungen werden auf eine, wie zuvor beschrieben, analoge Art geprüft und ermittelt. Eine Lokalisierung des jeweiligen Fehlers bzw. der Schadstelle ist damit möglich.

Wenn beispielsweise unterirdische Stromtrassen durch Erdbewegungen oder durch Beschädigungen von oben Defekte aufweisen, so wird mit der Messapparatur die entsprechende Störfrequenz gemessen, wobei der an der Schadstelle in der Regel vorhandene erhöhte Widerstand im Stromfluss durch die ohnehin im Fluggerät vorhandene IR-Thermalsensorik unterstützend sichtbar gemacht und aufgezeichnet wird. Ein Einsatz eines Thermalscanners ist ebenfalls oder auch zusätzlich möglich.

Mit der erfindungsgemäßen Messapparatur bzw. dem mit dieser Messapparatur ausgestatteten Fluggerät und mit dem Verfahren, welches mit dem erfindungsgemäßen Fluggerät durchgeführt wird, werden auch komplett gebrochene Leitungen lokalisiert, was darüber erfolgt, dass der Erdboden bei gebrochener Leitung eine andere Leitfähigkeit aufweist und diese auch in einer Veränderung der darüber befindlichen Vegetation oder Umwelt nachweisbar ist. Die ermittelten Störstellen können in analoger Weise hörbar und mit einem bildgebenden Element sichtbar gemacht werden. Wiederum werden alle ermittelten Daten vorzugsweise automatisch mit dem GNSS-Signal, d. h. einem satellitengestützten Signal, gekoppelt. Zusätzlich kann vorzugsweise mittels eines Distanzmessers und der Winkelbestimmung der UV- und IR-Kamera eine exakte Orts- und Lagebestimmung des Fehlers bzw. der Störstelle stattfinden. Vorzugsweise wird ein Thermalscanner eingesetzt, mittels welchem ein gegenüber herkömmlichen Thermalkameras größerer Winkelbereich und größerer Wellenlängenbereich abgescannt werden kann. Dies ist vor allem bei unterirdisch verlegten Stromtrassen sinnvoll, bei denen der tatsächliche Verlegungsort gegebenenfalls nicht exakt bekannt ist.

Das vorzugsweise eingesetzte hochauflösende LIDAR-System erfasst im Bereich der Schadstellen Unregelmäßigkeiten durch seine hohe Punktdichte im Bereich von 1.500 Pixel/m², welche dann entsprechend gut sichtbar sind und dokumentiert werden können.

Die ermittelten Fehler bzw. Fehlerzustände werden in der rechnergestützten Einheit entweder an Bord bereits ausgewertet oder werden mittels Live-Übertragung über diverse funkgestützte Übertragungsmöglichkeiten in entsprechenden Rechneranlagen am Boden gespeichert.

Gemäß einem weiteren Aspekt der Erfindung weist das zur Durchführung des Verfahrens verwendete Fluggerät eine Sensorik für eine Erfassung von Fehlern, Mängeln, Betriebs- und Materialzuständen an Energiefreileitungssystemen, eine Mehrzahl von hochauflösenden Digitalkameras für Bilddaten der Systeme und ein hochauflösendes Laserscansystem am und/oder im Fluggerät auf. Die Sensorik, die Digitalkameras und das Laserscansystem sind in Montageeinheiten angebracht, wobei ein Computer innen im Fluggerät vorgesehen ist, mittels welchem die aus den Einheiten gewonnenen drei Mess- beziehungsweise Inspektionsdaten miteinander korreliert werden, deren Daten verarbeitet und entsprechende Empfehlungen für notwendige oder anstehende Reparaturen und/oder Instandhaltungen sowie Ausfallwahrscheinlichkeiten ermittelt und einer Ausgabeeinheit zugeführt werden.

Vorzugsweise weist die Messtechnik eine Sensorik mit Ultraviolett- und/oder Infrarotsensoren sowie Lagesensoren, mehrere hochauflösende Digitalkameras, vorzugsweise spiegelfreie, mit einer Mindestauflösung von 25 bis 350 Megapixel mit mechanischer oder elektrischer oder elektro-mechanischer Stabilisierung von sowohl Kamera als auch Objektiv sowie den hochauflösenden Laserscanner mit 360° Vollkreis in der Vertikalen rundum auf. Die gewonnenen Daten werden jeweils dem Computer zugeführt und in diesem entsprechend korreliert, so dass sämtliche Daten miteinander verbunden sind und eine eindeutige Zuordnung eines Ereignisses oder eines Schadenfalls möglich ist. Vorzugsweise sind die Sensorik und der Laserscanner mit einer Universalvermessungsantenne gekoppelt, über welche die gewonnenen zusammengesetzten Signale des Satellitennavigationssystems empfangbar sind und nach Empfang deren Aufspaltung in für einen jeweiligen Verarbeitungsprozess erforderliche Signaldaten erfolgt. Vorzugsweise werden die GPS-Signale in L1 und L2 aufgeteilt. L1 wird dabei vorwiegend für den zivilen Bereich genutzt, während L2 normalerweise dem militärischen Bereich vorbehalten ist, bei entsprechenden Vereinbarungen beziehungsweise Verträgen aber auch für diese hier gemäß der Erfindung zu lösenden Aufgaben mitverwendet wird. Vorzugsweise wird beispielsweise für die Inspektion von Fundamenten von Masten zusätzlich im Fluggerät ein Radarsystem eingebaut, mittels welchem im Sinne eines Bodenradars in der Erde befindliche Fundamente entsprechend überwacht werden können.

Vorzugsweise ist das Fluggerät ein bemannter Drehflügler, insbesondere ein Helikopter. Mittels der im Rechner ablaufenden Prozesse für die Flugführung werden sämtliche erforderliche Daten erfasst, zusammengeführt und ausgewertet. Auf Basis der zusammengeführten und miteinander korrelierten Daten erfolgt eine Einschätzung der nachfolgenden tatsächlichen Wartungsarbeiten an den oberirdisch oder unterirdisch verlegten Stromtrassen einschließlich von deren Umfeld, wobei die Empfehlungen für entsprechende Wartungsarbeiten sofort und direkt ausgegeben werden können. Zu den Energiefreileitungssystemen gehören selbstverständlich auch die entsprechenden Trag-, Abspann- oder Portalmaste sowie Umspannwerke. Mittels der gewonnen Laserscandaten, die mit einer Auflösung von bis zu 1.500 Punkten bzw. Pixeln pro Quadratmeter die Möglichkeit schaffen, die Leitungsstruktur wie z. B. der Masten und Umspannwerke detailliert hinsichtlich ihrer Beschaffenheit und Abmessungen aufzunehmen und für die exakte Berechnung im einstelligen Millimeterbereich die Abstände zu den einzelnen Baugruppen eines Freileitungsmastes oder von Bauelementen in Umspannwerken zu bestimmen. Ein wesentlicher Vorteil dieser umfassenden Aufnahme ergibt sich aus der Dichte der erzeugten Laserpunkte. Dadurch kann die gesamte Struktur der Freileitungen und der Umspannwerke beziehungsweise der Unterwerke sowie der stromerzeugenden und spannungsumwandelnden Infrastruktur in hochauflösender 3D-Form und 360° in sämtliche Richtungen gedreht und begutachtet werden. Aus der millimetergenauen Messung von Bauteilen der Freileitung und/oder von Abständen zueinander und/oder Verdrehungen können Veränderungen der Biegemomente der Mastkonstruktion durch Umwelteinflüsse und/oder mechanische Einflüsse bestimmt werden. Durch diese hohe Auflösung der Daten ist im Grunde genommen sogar eine millimetergenaue Positionsbestimmung der Maststandorte möglich. Im Rahmen der Befliegung der zu inspizierenden Freileitungen können auch die Durchhänge der Phasenseile bei den verschiedenen Außentemperaturen auf Basis der während des Fluges gemessenen Seiltemperatur mittels einer zusätzlichen Infrarot- beziehungsweise Thermalkamera bzw. eines Thermalscanners erfasst und für den Energieversorger entsprechend ausgewertet werden. Bei dieser Temperaturmessung erfolgt die Leiterseiltemperaturmessung eben von den dem Boden am nächsten verlaufenden Phasenseilen mit Blick vom Helikopter gegen den Himmel, um Hintergrundtemperaturschwankungen auszuschließen, die vorhanden wären, wenn beispielsweise die Messung gegen den Boden erfolgen würde. Wird gegen den Himmel beziehungsweise Weltraum gemessen, so liegt eine hohe Konstanz der Temperaturstrahlung vom Weltraum vor.

Bei der Inspektion von Fundamenten der Masten von Energiefreileitungssystemen wird vorzugsweise mit einem Bodenradar, mit Thermalscannern, Multispektralscannern und ähnlichen technischen Geräten gearbeitet, wobei diese zusätzlich in oder an dem Fluggerät angeordnet sind.

Die Übertragung insbesondere der Bilddaten vom Helikopter beispielsweise zum Energieversorger kann dabei live erfolgen, sodass der am Boden befindliche Inspekteur des Energieversorgers direkten Einfluss auf eine Fehlerdetektion nehmen kann. Der Helikopter kann dabei an Stellen fliegen, an denen Fehler, Schäden oder Mängel zuvor detektiert worden sind. Entsprechende Ultraschallsensoren und Laserentfernungsmesser garantieren, dass ein Mindestabstand von 5 Metern zur Freileitung eingehalten wird. Sofern die Daten nicht im bordeigenen Computer ausgewertet werden, sondern zu einer Bodenstation geschickt werden, ist dennoch die mit einem derartigen Helikopter in einer Befliegung abfliegbare Strecke nahezu beliebig lang.

Um insbesondere die Störstellen und Defekte an den stromführenden Leitungen bei Inspektionsflügen erfassen zu können, weist das erfindungsgemäße Fluggerät also eine weitere Sensorik auf, welche eine Messeinrichtung bzw. Messapparatur speist, welche die an der Stromleitung, gleich ob es sich um eine Überlandleitung oder im Erdboden verlegte Leitung handelt, vorhandenen Fehler, Mängel und/oder Defekte an den stromführenden Leitungssystemen, welche zu entsprechenden Störungen des elektromagnetischen Feldes führen, die messbar sind, mittels einer Audioeinrichtung hörbar und/oder mittels einer bildgebenden Einrichtung sichtbar machen kann. In einer Verarbeitungseinheit werden diese Daten gespeichert, aus denen dann ein Inspektionsprotokoll mit direkter Angabe der Fehler bzw. Defekte und des Grades der Schädigung angezeigt oder ausgedruckt werden kann, sodass auf Basis eines derartigen Störungen ausweisenden Inspektionsprotokolls unmittelbar entsprechende Reparaturen veranlasst und durchgeführt werden können.

Gemäß der Erfindung werden somit ein neues Verfahren und ein Fluggerät bereitgestellt, welche der Überwachung und Koordinierung von Wartungsmaßnahmen an stromführenden Freileitungssystemen auf Basis von in einer einzigen Befliegung gewonnenen umfassenden Daten dienen.

Weitere Vorteile, Details und Anwendungsmöglichkeiten der vorliegenden Erfindung werden in der nachfolgenden Zeichnung detailliert erläutert. In der Zeichnung zeigen:
- Figur 1:: eine prinzipielle Darstellung eines Mastes im Gelände für eine Stromtrasse mit einem Helikopter im Einsatz für eine visuell durchgeführte Inspektion gemäß dem Stand der Technik;
- Figur 2:: ein Strommast im Gelände mit einem Helikopter zur Durchführung einer Inspektion mittels Laserscannung gemäß dem Stand der Technik;
- Figur 3:: ein Strommast im Gelände mit einem Helikopter zur Inspektion mittels Sensorik gemäß dem Stand der Technik;
- Figur 4:: ein Strommast in stilisierter Form im Gelände mit einem mit Sensorik, Kameras und Laserscansystem ausgerüsteten Helikopter für eine kombinierte Inspektion mit einer einzigen Befliegung gemäß der Erfindung;
- Figur 5:: eine prinzipielle Darstellung eines mit Sensorik, mehreren hochauflösenden Kameras und einem Laserscansystem ausgestatteten Fluggerätes als erfindungsgemäßer Helikopter zur Durchführung des erfindungsgemäßen Verfahrens; und
- Figur 6:: ein prinzipielles Flussdiagramm für die kombinierte Inspektion von Stromleitungen eines Freileitungsnetzes mittels einer einzelnen Befliegung gemäß der Erfindung.

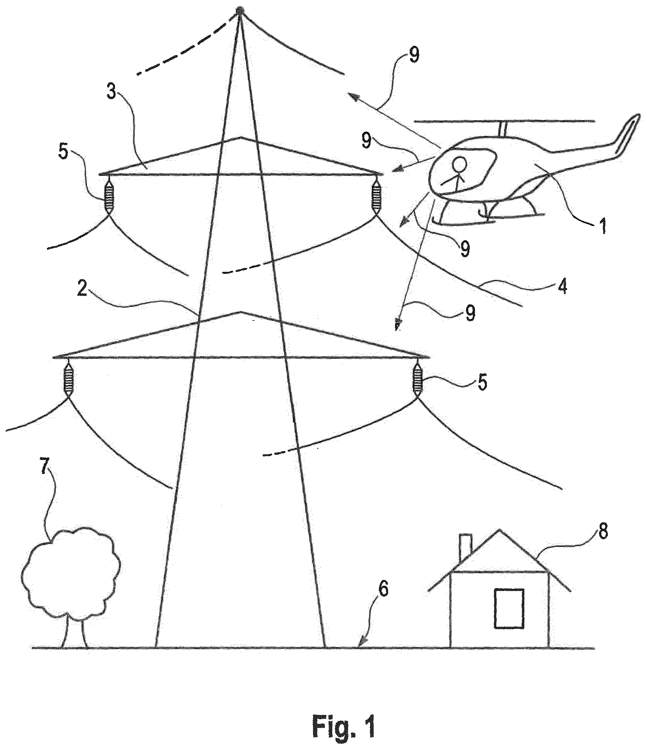

In Figur 1 ist ein Strommast 2 für eine Energiefreileitung im Gelände in stilisierter Form dargestellt, bei welchem eine mittels eines Helikopters 1 realisierte visuelle Inspektion durchgeführt wird. Die visuelle Inspektion wird in bekannter Art und Weise durchgeführt, indem mittels eines Fluggerätes in Form eines Helikopters 1 bzw. Hubschraubers im Bereich eines Strommastes 2 an entsprechenden Traversen 3 des Strommastes 2 mittels Isolatoren 5 befestigter Stromleitungen 4 eine visuelle Inspektion mittels Kameras (nicht dargestellt) visuell vorgenommen wird, indem mittels mehrerer Kameras entsprechende Bilddarstellungen für entsprechende Mess- und Aufnahmerichtungen 9 durchgeführt werden. Der Strommast 2 steht im freien Gelände auf dem Erdboden 6, und das Fluggerät 1 überfliegt Vegetation 7 und Bebauungen 8 in Höhe der Traversen 3 des Strommastes 2, und zwar seitlich davon. Neben dem Piloten ist ein nicht dargestellter Mitarbeiter des Stromversorgungsunternehmens oder ein von diesem Unternehmen beauftragter Fachmann mitfliegend, durch welchen manuell die Kameras bedient werden und verschiedene Elemente wie Strommast, Isolierung 5, Stromleitungen 4, Geländestruktur 6 einschließlich Vegetation 7 und Bebauung 8 aufnehmen. Bei den allgemeinen visuellen Inspektionsflügen muss der die entsprechenden Bilder aufnehmende mitfliegende Inspekteur manuell in eine Liste die Orte notieren, an welchen er entsprechende Fotos gemacht hat, sofern die Kameras nicht in der Lage sind, ortsbezogene Daten gleich mitzuspeichern. Aus diesem bekannten visuellen Inspektionsverfahren wird deutlich, dass eine derartige spezielle Befliegung nur für die Gewinnung von Bilddaten durchgeführt wird.

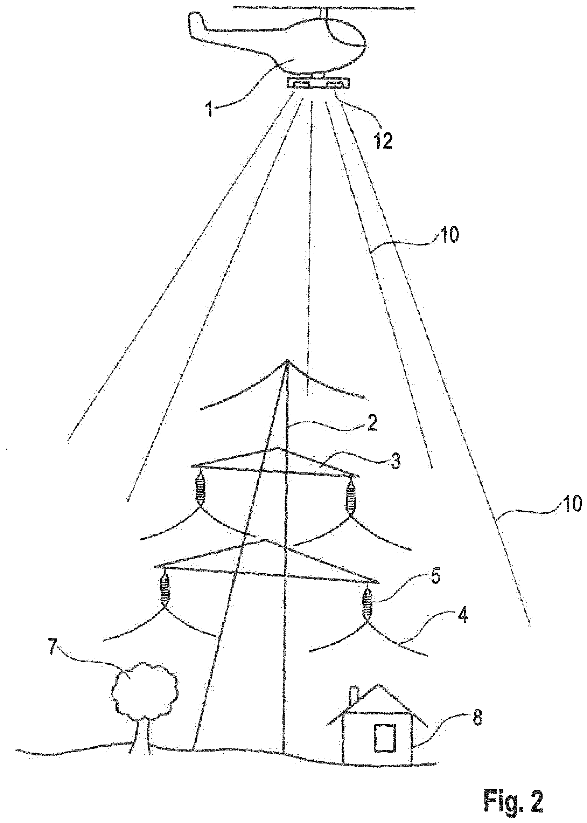

Dies bedeutet aber, dass für weitere Aufgaben der Datenerfassung weitere Befliegungen erforderlich sind. So ist in Figur 2 eine im Stand der Technik bekannte Situation dargestellt, bei welcher ein Helikopter mit einem Laserscansystem, und zwar in diesem Fall mit einem LIDAR-System ausgestattet ist und in deutlicher Höhe über dem Strommast 2 Laserscannungen des Bereiches des Strommastes 2 im Gelände unter Einbeziehung der Vegetation 7 und/oder einer gegebenenfalls vorhandenen Bebauung 8 sowie von dem Strommast 2 selbst mit seinen Traversen 3 und den daran befestigten Isolatoren 5 sowie die daran getragenen Stromleitungen 4 vornimmt, indem das Laserscansystem nach unten ausgerichtet wird und eine Mess- bzw. Aufnahmerichtung 10 bildet. Das Fluggerät 1 bzw. der Helikopter überfliegt in relativ großer Höhe die Stromleitungen mit einer Geschwindigkeit von 35 bis 80 km/h in einer Höhe von bis zu 200 m über der maximalen Masthöhe bzw. der Höhe der Stromleitungen 4. Daraus wird ersichtlich, dass bei diesem bekannten System für die Gewinnung von Laserscandaten andere Flugbedingungen während der Befliegung eingehalten und genutzt werden müssen, als es für die visuelle Inspektion mittels der Kameras gemäß Figur 1 erforderlich ist, bei welcher der Pilot den Helikopter seitlich von Traversen der Masten 2 führt, damit der Inspekteur entsprechende Kameraaufnahmen von dem Zustand oder eine Beschädigung aufweisenden Elementen oder Teilen der Energiefreileitung vornehmen kann.

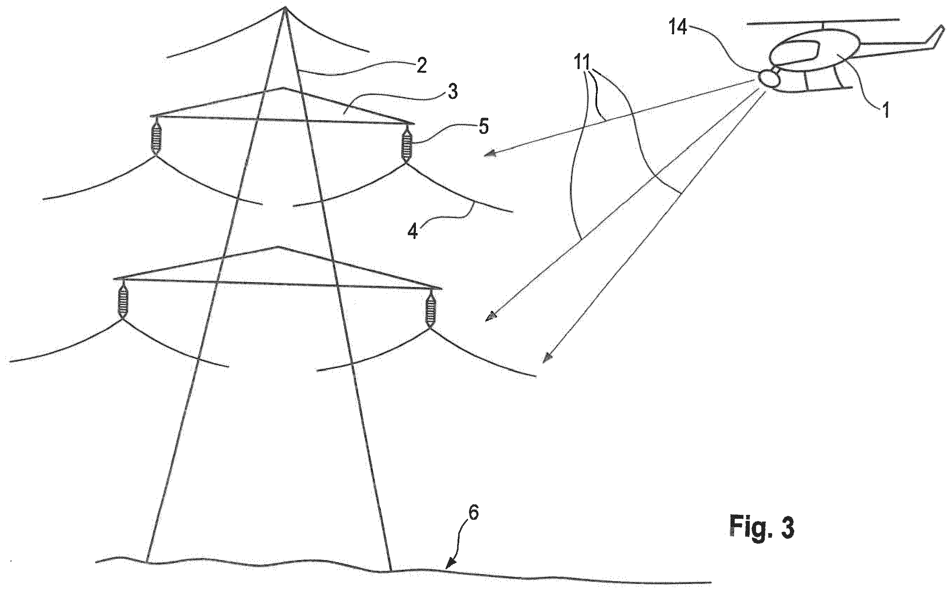

In Figur 3 ist die Situation für eine weitere separate Befliegung einer Energiefreileitung mittels eines Fluggerätes 1 in Form eines Helikopters 1 dargestellt. Der Strommast 2 mit seinen Traversen 3, an welchen die Isolatoren 5 gezeigt sind, an welchen die stromführenden Leitungen 4 angebracht sind, ist in stilisierter Darstellung auf dem Erdboden 6 dargestellt. Der Helikopter 1 selbst ist mit einer Sensorik 14 versehen, welche UV-, IR-, RGB-, Thermal-, Lage- und Coronasensoren aufweist. Dargestellt ist die Aufnahmerichtung 11 für die Messung mittels der angegebenen Sensoren der im Fluggerät 1 installierten Sensorik 14. Anders als bei der visuellen Inspektionsdurchführung gemäß Figur 1, bei welcher das Fluggerät 1 für Hochspannungsleitungen in einer Entfernung von 5 bis 15 m seitlich von den Strommasten 2 und 1,5 m bei Niederspannungsleitungen ebenfalls seitlich von den Strommasten 2 fliegt, wird für die Durchführung einer Befliegung für die entsprechenden Messungen bzw. Aufnahmen mittels der im Fluggerät 1 installierten Sensorik 14 eine Entfernung vom aufzunehmenden Element der Energiefreileitung im Bereich von 30 bis 50 m vorgesehen, wobei die Betriebsflughöhe im Wesentlichen auf ein und derselben Flughöhe im Bereich der oberen Traverse 3 erfolgt. Die Fluggeschwindigkeit wird mit 25 bis 45 km/h für diese Befliegung realisiert. Die in den Figuren 1 bis 3 für unterschiedliche Mess- bzw. Aufnahmesituationen durchgeführten unterschiedlichen Befliegungen haben zur Folge, dass zur Gewinnung aller nötigen Daten für eine umfassende Inspektion zumindest drei Befliegungen erforderlich sind. Dies stellt einen enorm hohen Aufwand dar und erschwert in erheblichem Maße eine Korrelation von den in den jeweiligen Befliegungen gewonnenen Daten zueinander, so dass trotz eines relativ hohen Aufwandes an zusätzlicher manueller Arbeit, beispielsweise Excel-Tabellen zu führen, eine Korrelation der mit den einzelnen Befliegungen gewonnenen Daten allenfalls nur sehr eingeschränkt möglich ist. Es wird vor allen Dingen aus den unterschiedlichen Bedingungen für die jeweiligen Befliegungen gemäß den Figuren 1 bis 3 deutlich, dass sowohl hinsichtlich der Abstände als auch der Fluggeschwindigkeiten für die einzelnen Mess- bzw. Aufnahmedaten kaum gemeinsame Bedingungen existieren, so dass im Grunde genommen die einzelnen Befliegungen mit ihren einzelnen Messaufgaben und dafür einzuhaltenden Bedingungen sich einander ausschließen.

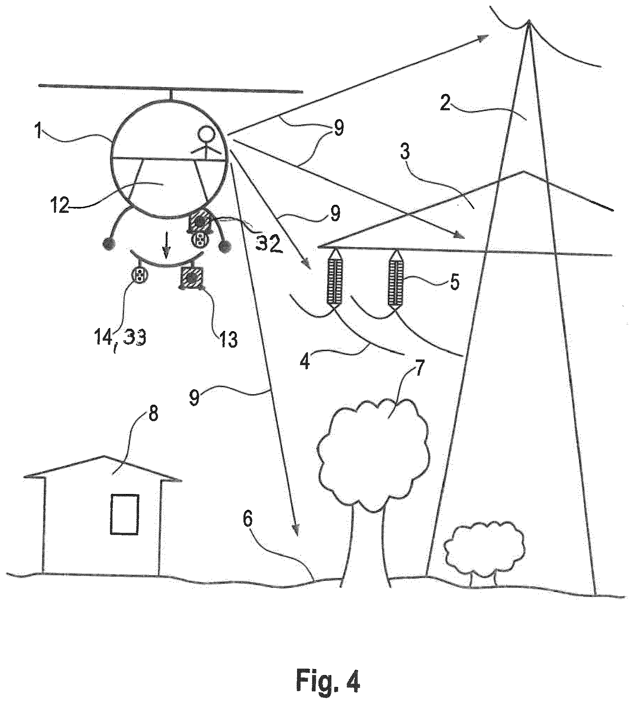

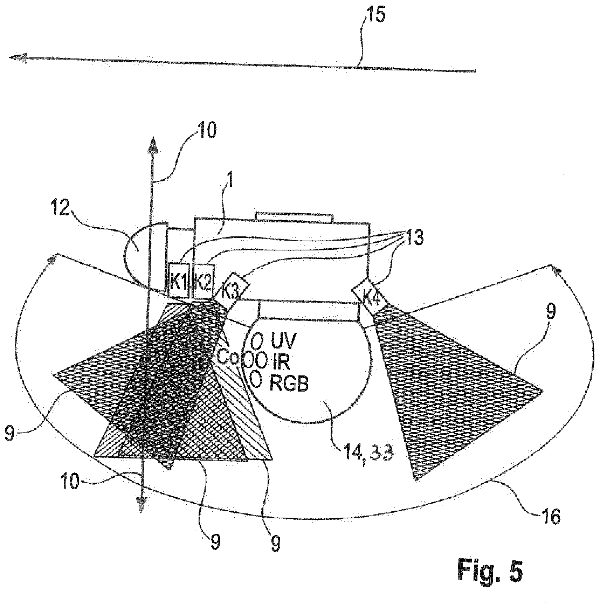

Demgegenüber zeigen die Figuren 4 und 5 die Situation für eine zur Inspektion durchgeführte einzige Befliegung unter Einbeziehung von hochauflösenden Bilddaten, hochauflösenden Laserscannungen und entsprechender Sensorik (siehe Figur 4) sowie ein mit den entsprechenden Mess- und Aufnahmeeinrichtungen ausgebildetes Fluggerät 1 (siehe Figur 5) gemäß der Erfindung. Das gesamte Datenerfassungs- und Datenverarbeitungssystem ist so ausgebildet, dass erhebliche Datenmengen zuverlässig in kürzester Zeit verarbeitet werden können.

Die in Figur 4 dargestellte erfindungsgemäße kombinierte Inspektionsbefliegung einer Stromleitung als Freileitung im Gelände wird mit einem Fluggerät 1 in Form eines Helikopters durchgeführt, in welchem ein hochauflösendes LIDAR-System 12 als Laserscansystem, eine Sensorik 14, welche UV-, IR-, RGB-, Thermal-, Lage- und/oder Corona-Sensoren aufweist, sowie mehrere, an verschiedenen Stellen des Fluggerätes 1 befestigte hochauflösende Kameras 13 vorgesehen und miteinander kombiniert sind, welche direkt nach unten wie auch in Flugrichtung nach vorn und nach hinten digitale Bilddaten, d. h. Aufnahmen, machen können. Es ist zusätzlich außerdem möglich, dass der mitfliegende Inspekteur manuell Fotos von ausgewählten Stellen aufnimmt, wobei die Kameras bzw. die Kamera 13 dann in die Mess-/Aufnahmerichtung 9 zu verschiedenen Stellen gerichtet sein kann. Die Sensorik 14 und die Kamera 13 können dabei an der Unterseite des Fluggerätes 1 befestigt sein. Es ist ebenso möglich, dass die Sensorik 14 und die Kamera an gegenüberliegenden Seiten an der Unterseite des Helikopters 1 befestigt sind. Dies ist in Figur 4 durch den angedeuteten Bodenbereich des Helikopters 1 mit dem Pfeil dargestellt, welcher den Unterbodenbereich als separates Teil zeigt. Zur Messung von Störstellen und Defekten an den stromführenden Leitungen weist der Helikopter 1 eine Messapparatur 32 mit einer weiteren Sensorik 47 auf. Dabei werden Störungen am elektromagnetischen Feld gemessen.

Das erfindungsgemäße System bzw. das mit dem erfindungsgemäßen Fluggerät 1 durchgeführte Verfahren basiert nun dem Grunde nach darauf, dass alle drei Mess- bzw. Aufnahmekomplexe, d. h. die hochauflösenden Kameras 13, die Sensorik 14 und das hochauflösende LIDAR-System 12, d. h., das Laserscansystem, miteinander gekoppelt sind, so dass sämtliche Daten zueinander korreliert werden und eine eindeutige räumliche Lage wie auch eine Ortsspezifizierung möglich sind. Die verwendete Mess- und Aufnahmetechnik ist, insbesondere die Sensorik 14 und das Laserscansystem 12, über eine Universalvermessungsantenne mit dem Satellitennavigationssystem gekoppelt, so dass die empfangenen Daten für die verwendeten Mess- bzw. Aufnahmeeinrichtungen bei entsprechend vorgenommener Datenaufteilung für die verschiedenen Ablaufprozesse verwendet werden können.

Es erfolgt also eine weitestgehend automatisierte, kombinierte und vollständige Überwachung sowohl der Betriebszustände als auch der physikalischen Eigenschaften als auch von aufgetretenen Schäden oder beginnenden Schäden, welche zukünftig möglicherweise zu einem Ausfall der Energieversorgung führen könnten. Diese Ermittlung und Zusammenstellung all der genannten Daten und Informationen führt zu einer prophylaktisch orientierten Wartung und Instandhaltung einschließlich notwendiger Sofortreparaturen. Das verwendete System bearbeitet die Daten nun derart, dass konkrete Handlungsempfehlungen, Zeitbereiche, bis zu denen bestimmte Reparaturen oder Korrekturen vorgenommen werden müssen, und gibt diese Informationen auf einer Anzeigeeinrichtung an den Energieversorger oder an eine von diesem beauftragte Firma weiter. Die Datensätze können dabei einschließlich der Handlungsempfehlungen ausgedruckt oder auf elektronischem Wege an die verantwortlichen Kunden des Befliegungsunternehmens weitergegeben werden.

Der Helikopter 1 fliegt mit einer Geschwindigkeit von 0 bis 60 km/h mit einem Abstand zu Hindernissen im Bereich von 0 bis 50 m in einer Betriebshöhe von nahe 0, d. h. im Bodenbereich bis zur Höhe der Masten. Die Mess- bzw. Aufnahmetechnik ist nun so konzipiert und so aufeinander abgestimmt, dass der Helikopter 1 in einer definierten Arbeitshöhe, vorzugsweise im Bereich der jeweiligen Traversen 3 seitlich der Energiefreileitungen und damit seitlich der Masten 2 fliegen kann und dennoch alle drei grundsätzlichen Mess- und Aufnahmeaufgaben zuverlässig erfüllen kann. Dies war bei bisherigen bekannten Systemen mittels einer einzigen Befliegung nicht möglich. Unter einer Befliegung ist im Zusammenhang mit dem hier zugrundeliegenden Gegenstand eine Befliegung in einer Richtung gemeint. Nicht gemeint ist es, die Messungen bzw. Aufnahmen in einem Hin- und einem Rückflug durchzuführen. Ein Hin- und ein Rückflug sind in der Regel zwei Befliegungen gleichzusetzen. Es ist im Stand der Technik nicht bekannt, alle drei Mess- und Aufnahmeaufgaben in einer einzigen Befliegung durchzuführen und auch noch eine Datenverarbeitungseinheit als Computer mit entsprechender Verarbeitungseinheit in einem einzigen Fluggerät 1, vorzugsweise einem Helikopter, unterzubringen.

Figur 5 zeigt ein erfindungsgemäßes Fluggerät 1, in welchem die beschriebene komplette Sensorik 14 für alle Mess- und Aufnahmeaufgaben in sich vereinigt sind. Die UV-, IR,- RGB-, Thermal-, Lage- und Corona-Sensoren umfassende Sensorik 14 sowie Videokameras und das hochauflösende LIDAR-System sind in einem kugelförmigen Behälter aufgenommen, welcher frei drehbar, d. h. vertikal und horizontal drehbar, ist und zudem vollkardanisch und kreiselstabilisiert aufgehängt ist. Aufgrund beschränkter Zuleitung für ein derartiges Fluggerät 1 ist eine wesentliche Voraussetzung, dass die gesamte Messtechnik, Aufnahmeeinrichtung wie auch Datenverarbeitungseinrichtung leicht und klein genug ist, dass alles problemlos im Fluggerät 1 nicht nur untergebracht werden kann, sondern auch so angeordnet und ausgerichtet werden kann, dass sämtliche Mess- und Aufnahmeaufgaben mit der Sensorik 14, den Kameras 13 und dem Laserscansystem 12 durchgeführt werden können und über das gleichzeitige Anordnen einer Datenverarbeitungsanlage innerhalb des Fluggerätes 1 sämtliche über die drei genannten Mess- und Aufnahmekomplexe gewonnenen Daten miteinander und zueinander korreliert werden können. Dadurch können die Daten nicht nur einen Gesamtüberblick über mögliche Wartungen, durchzuführende Reparaturen oder vorhandene oder sich entwickelnde Schäden verschaffen, sondern die gewonnen Daten werden auch in eine entsprechende Datenbank eingepflegt. Dadurch wird für zukünftige Befliegungen für Inspektionen und Wartungen und Reparaturen ein größer werdender Datensatz gebildet, welcher es ermöglicht, aus ermittelten Daten genaue, zuverlässige und den tatsächlichen Verhältnissen entsprechende Vergleichsdaten zu gewinnen.

Im vorderen Bereich des Fluggerätes 1 ist das Laserscansystem 12 angeordnet, das sogenannte hochauflösende LIDAR-System, welches in der Mess-/Aufnahmerichtung 10 eine Laserscannung durchführt. Das Fluggerät 1 hat des Weiteren vier Kameras 13, als K1 bis K4 bezeichnet, angeordnet, welche jeweilige kegelförmig ausgebildete Bildabdeckbereiche in die jeweilige Aufnahmerichtung aufweisen. Dazu sind die Kameras K1 und K2 im vorderen Bereich des Fluggerätes 1 angeordnet und sind im Wesentlichen senkrecht nach unten in Richtung auf den Erdboden 6 gerichtet. Die beiden Kameras K3 und K4 sind jeweils in Flugrichtung 15 nach vorne (K3) bzw. in Flugrichtung 15 nach hinten (K4) gerichtet.

An der Unterseite des Fluggerätes 1 ist eine Sensorik 14 angeordnet, welche UV-, IR-, RGB- und zumindest auch Corona-Sensoren aufweist. Die Sensoren sind so angeordnet und so schwenkbar, dass ein Schwenkbereich 16 der Sensorik 14 in der prinzipiell dargestellten Weise eine entsprechende Messabdeckung realisiert.

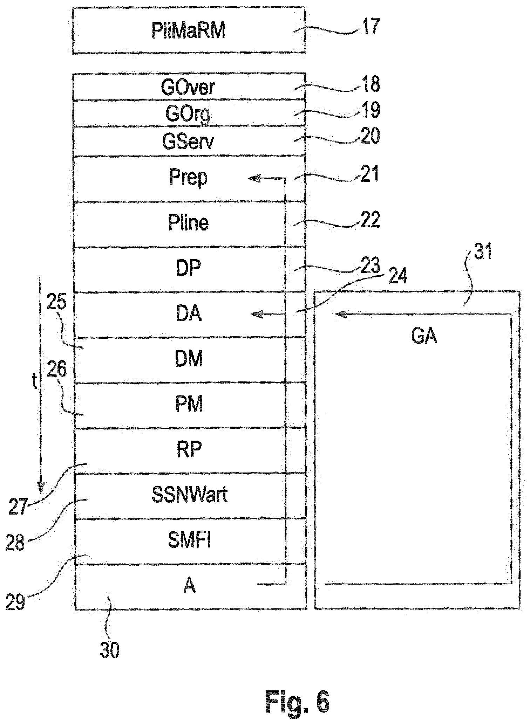

Und schließlich ist in Figur 6 ein Flussdiagramm dargestellt, aus dem die einzelnen Bestandteile und Ablaufschritte für die Gewinnung der Daten mittels der drei Mess- bzw. Aufnahmeeinrichtungen zur umfassenden Überwachung von Stromfreileitungen einschließlich eine Zuverlässigkeitsmanagementsystems ersichtlich sind.

Die Überwachung und das Zuverlässigkeitsmanagement 17 von Stromfreileitungen (PliMaRM) umfassen die nachfolgenden, das erfindungsgemäße Gesamtsystem abdeckenden Schritte bzw. Komplexe. Zunächst wird ein Stromnetz-Überblick (GOver) 18 erstellt. Grundlage der Inspektionen sind beispielsweise Informationen für den Piloten vom den Auftrag erteilenden Energieversorger, welches seiner Netze zu inspizieren ist. Dazu werden erste Gespräche mit dem Energieversorger geführt, um abzustecken, was seitens des Energieversorgers als Ziel der Inspektionen erwartet wird.

Im Rahmen der sogenannten Stromnetz-Organisation (GOrg) 19 werden Informationen zusammengestellt bezüglich des Aufbaus und der Organisation des beauftragenden Energieversorgers, um direkte Verbindungsstellen zu dem die Befliegung im Auftrag des jeweiligen Energieversorgers durchführenden Unternehmen festzulegen. Dabei wird definiert und dem die Befliegung durchführenden Unternehmen eine Aufschlüsselung bzw. ein Informationskonvolut, beispielsweise hinsichtlich sogenannter Reporting-Stellen, d. h. der verantwortlichen Stellen beim Energieversorger übergeben, an welchen die von der Befliegung gewonnenen Daten zu übertragen sind. Dabei eingeschlossen ist eine Übersicht, wer von wem Daten erhält. Dies schließt auch ein, welche entsprechenden Freigaben bezüglich der Datennutzung erfolgen müssen. Unter diesem Komplex ist ebenfalls integriert ein Meldesystem bei schwerwiegenden Ereignissen, d. h. bereits zwingend notwendiger Reparaturen, weshalb entsprechende Freigaben zur Durchführung von Arbeiten an Freileitungen oder in der Nähe der Freileitungen und der Umspannwerke erfolgen und veranlasst werden müssen.

Im Rahmen des nachfolgenden Komplexes der Stromnetz-Wartung (GServ) 20 wird ein Überblick über das eigene Netz des beauftragenden Energieversorgers bereitgestellt, um die Festlegung von besonderen Schwerpunkten für die Inspektionen treffen zu können. Darin eingeschlossen ist, ob die Inspektionen nur am Kernnetz oder auch an zum Kernnetz zuzüglich besonders gelegener Netzbereiche gehörender Leitungen durchgeführt werden müssen. Zusätzlich eingeschlossen ist die Festlegung der Durchführung von Inspektionen mit besonders hoher Dichte an Schadensereignissen. Besonders bei letzteren ist es erforderlich, dass vor allem diese Bereiche der Leitungen besonders intensiv und mit sämtlicher vorhandener Messtechnik inspiziert werden, sodass die entsprechenden Handlungsempfehlungen automatisiert ausgegeben werden können. Im Rahmen dieses Arbeitskomplexes ist es auch vorgesehen und nötig, die mitfliegende Inspektionscrew mit entsprechenden Befugnissen im Auftrag des Energieversorgers auszustatten und auch die entsprechenden Freigabe- bzw. Arbeitsberechtigungen für den Energieversorger zu erteilen. Im Rahmen eines engen Austauschs zwischen dem beauftragenden Energieversorger und dem die Befliegung durchführenden Unternehmen wird das eigene Personal für Arbeiten an oder in der Nähe von Freileitungen für die Durchführung der Inspektion von Freileitungen jeglicher Spannungsebene entsprechend geschult. Derartige Module sind in das Datenverarbeitungssystem integriert. Darin einbezogen sind Fehlererkennung bzw. Mängelfeststellung, Typen der Technik der einzelnen Elemente (wie zum Beispiel die Art der Masten, der Umspannwerke, der Trafos, die Art der Isolatoren, der Aufhängungen, der Anbringung und der Art der Verbinder, etc.). Einbezogen im Sinne einer effektiven Vorbereitung auf die durchzuführende Inspektion ist auch die Schulung der Inspektionscrew bezüglich des Aufbaus des gesamten Energienetzes, deren Funktionen, der eingesetzten Technik für die jeweiligen Elemente, möglicher Ausfallszenarien und Ausfallwahrscheinlichkeiten sowie die Einflüsse des Energietransportes auf Bevölkerung und Wirtschaft und Umwelt wie auch die Einflüsse auf die im Fluggerät, d. h. im Hubschrauber, eingebaute Elektronik. Letzteres ist vor allen Dingen von Bedeutung, da je nach Inspektionsart, je nach äußeren Einflüssen bei der Inspektion stets ein negativer Einfluss auf vor allen Dingen empfindliche Elektronik im Hubschrauber auszuschließen ist. Zur Schulung der Inspektionscrew gehört auch der Aufbau der verwendeten Inspektionssoftware, einschließlich ihrer Anwendung und möglicher Ergänzungsmodule für weitere, bisher noch nicht in der Inspektionssoftware vorhandene Funktionen und Aufgaben der durchgeführten Messungen bzw. Inspektionen. Das bedeutet, dass im Falle von nicht vorhandenen oder gegebenenfalls auch momentan nicht verfügbaren Daten in Vorbereitung und vor allen Dingen auch während der Befliegung entsprechende Adaptionen veränderter Bedingungen an die Software und die Auswerteelektronik vorgenommen werden können und müssen.

Im nächsten Schritt, welcher als Vorbereitung ("Prep") 21 bezeichnet wird, werden für die Aufbereitung und Übertragung der erforderlichen Daten des zu inspizierenden Freileitungsnetzes in die elektronische Verarbeitungseinheit, d. h. den Rechner, eingegeben, und zwar des Freileitungsnetzes, welches zu inspizieren und zu überwachen ist, entsprechend dem Auftrag des Energieversorgers. Dazu werden Daten bezüglich der Maststandorte, der Standorte der Unterwerke oder Umspannwerke, der Standorte der Transformatorenstationen, die Typen der Masten, deren Bauformen, die verschiedenen Spannungsebenen, auch entsprechende Eigentumszuordnungen und ähnliche Dinge eingegeben, sodass während einer Befliegung die entsprechende Basis und Zuordnung der gewonnenen Daten zu den tatsächlich im Auftrag zur Inspektion stehenden Netze oder Netzabschnitte stehen. Sofern Fehler bzw. Mängel oder diese betreffende Ereignisse bereits, beispielsweise von früheren Befliegungen, bekannt sind, wird deren Schweregrad festgelegt und in das Datenverarbeitungssystem ebenfalls eingegeben oder von diesem ermittelt. Festgelegt wird auch der grundlegende Arbeitsaufwand zur Behebung dieser genannten Mängel, was in die Datenverarbeitungsanlage eingegeben und dort im Rahmen eines Speichers abgespeichert wird, damit es für zukünftige Einschätzungen eine entsprechende Datengrundlage bildet. Insgesamt wird im Rahmen dieses Ablaufschrittes eine Ersteinschätzung der gewonnenen Kenntnisse auf Basis von Annahmen und bisher verfügbaren Daten vorgenommen. Dies trägt wesentlich zur effektiven Durchführung der entsprechenden Befliegung bei.

Erst nach diesen grundlegenden vorbereitenden Arbeiten wird die Überwachung der Stromleitung (Pline) 22 im Rahmen des eigentlichen fliegerischen Einsatzes, d. h. der Befliegung, mit der entsprechend durch die Befliegung sich ergebenden Reihenfolge der Inspektionen durchgeführt. Dazu gehört die Beobachtung der Freileitungen, die Dokumentation von Fehlern, Mängeln oder Ereignissen, wobei die Einschätzung der Schwere eines festgestellten Ereignisses ebenfalls automatisiert mit Hilfe der Datenverarbeitungseinrichtung, d. h. des an Bord befindlichen zusätzlichen Computers, festgelegt wird.

Entsprechend der Schwere des Ereignisses wird vom Verarbeitungssystem eine sofortige Meldung im Fall von schweren Mängeln oder Ereignissen in Form einer Übertragung und Ausgabe von Bildern, Videos, etc. vorgenommen. Zum einen kann dadurch der Energieversorger unmittelbar Informationen erhalten, dass, möglicherweise unter Abweichung des in Schritt 21 vorgenommenen Ablaufs der Befliegung, ein zielgerichtetes Ansteuern des Ortes mit einem Mangel, welcher sofort zu beseitigen ist, möglich ist, sodass unter Mitwirkung oder auch wesentlicher Verantwortung der Flugbesatzung ein sofortiger Eingriff erfolgen kann. Sofortige Eingriffe im Sinne eines Vermeidens von Gefährdungssituationen am Boden wären zum Beispiel das Durchgeben von Informationen an entsprechende Stellen, zum beispielsweise Stilllegen von Baustellen in einem Sicherheitsbereich von Freileitungen, wenn beispielsweise auch festgestellt wird, dass im Schwenkbereich oder Arbeitsbereich von Kränen oder Baggern einzuhaltende Sicherheitsabstände nicht gewährleistet sind. Derartige relevante Daten werden direkt über eine vorherige automatisierte Ermittlung live an den beauftragenden Energieversorger übertragen.

Der Schritt der Überwachung der Stromfreileitung kann, wie zuvor beschrieben, in Abweichung eines vorgegebenen Flugprofils erfolgen; in der Regel wird jedoch, wenn schwere Mängelereignisse nicht vorhanden sind, mit dem gemäß Schritt 21 aufbereiteten Flugprofil die Befliegung durchgeführt. Während der Befliegung wird in der Regel mit sämtlicher an Bord installierter Messtechnik die Energiefreileitung messtechnisch, bildtechnisch, etc. überwacht, wobei jederzeit eine Zuordnung der gewonnenen Daten zu den entsprechenden Orten im System erfolgt. Der gesamte Datensatz beinhaltet dann alle Informationen, um Reparatur-, Wartungs- oder Bauteilaustausch-Arbeiten entsprechend zu planen, wobei das System so aufgebaut ist, dass derartige Arbeiten an eine Ausgabeeinrichtung hinsichtlich des Umfangs und auszuwechselnder oder zu erneuernder Bauteile automatisiert übertragen werden, ohne dass größere Meetings bei den beteiligten Abteilungen und Mitarbeitern des Energieversorgers erforderlich wären.

Im nächsten Schritt der Datenverarbeitung (DP) 23 erfolgt die weitergehende Datenverarbeitung nach den Inspektionsflügen auf Basis der durch das Sensorsystem, den Laserscanner, die Tageslichtdigitalkameras sowie der visuell festgestellten Missstände erfolgten Inspektionen. Während der Datenverarbeitung erfolgt die Korrelation der aus den einzelnen Sensorsystemen bzw. Messsystemen gewonnenen Daten zueinander. Darin eingeschlossen ist die Erzeugung von digitalen Höhenmodellen des Bodenverlaufs, und zwar auf Basis von erzeugten Laserdaten mittels einer sogenannten Punktwolke entweder mit Bewuchs und Gebäuden oder ohne Bewuchs und Gebäude, und zwar mit einer sehr hohen Messgenauigkeit. Im Ergebnis wird eine 3D-Modellierung der gesamten Freileitungstechnik erstellt, sodass spätere Vermessungen von Abständen innerhalb der Freileitungstechnik oder beispielsweise Verformungen von Masten und Traversen wie auch andere belastungsbedingte Deformationen von Bauelementen an den Freileitungssystemen als Grundlage für eine umfassende und detaillierte und sichere und zuverlässige Auswertung miteinbezogen werden können.

Als nächster Schritt erfolgt die Datenanalyse (DA) 24. Im Rahmen der Datenanalyse werden die gewonnenen Daten analysiert, erfolgt eine Endbeurteilung in dem Sinne, dass eine Erweiterung der Erstanalyse während der Inspektion vorgenommen wird, wobei eine Auswertung der Laserdaten unter Einschluss folgender Unterschritte vorgenommen wird:
a) Nach den entsprechenden Vorgaben des die Inspektion beauftragenden Energieversorgers wird im Hinblick auf Vegetationsart, Wachstumsanalyse im Sicherheitsbereich der Freileitung, des Weiteren im Hinblick auf Abstände von Hindernissen unter und neben der Freileitung, auf Sicherheitsabstände zum Boden bezüglich landwirtschaftlicher Gesichtspunkte wie beispielsweise die Bauhöhe von Landmaschinen die erzeugte Punktwolke definiert.
b) Es erfolgt eine Messung der Veränderung der Freileitungstechnik bzw. des gesamten Leitungssystems hinsichtlich durch äußere Umstände wie Wetter, Bodenverwerfungen, Schneelast etc. erfolgende Verformungen, z. B. Torsion.
c) Es erfolgt des Weiteren eine Berechnung der verschiedenen Lastzustände der Freileitungen bei verschiedenen Außentemperaturen, und zwar an Hand der Laserdaten und der im Flug gemessenen Seiltemperaturen, wobei beide Messergebnisse miteinander korreliert und auf den jeweiligen örtlichen Bezug relativiert werden.
d) Des Weiteren werden der Einfluss der Vegetation unter und neben den Freileitungen auf die Sicherheit der Leitungen und der Einfluss auf die Umwelt in die Berechnung miteinbezogen.

Auf Basis dieses umfangreichen Datenkonvoluts, welches sich aus Messergebnissen und Berechnungsergebnissen und Korrelationsergebnissen ergibt, werden für alle erfassten und berechneten Mängel, Fehler oder Ereignisse die Arbeitsumfänge und die Reihenfolge sowie der zur Reparatur erforderliche Materialaufwand, der erforderliche Maschinenaufwand, die Anzahl von Reparaturstellen und der Arbeitsaufwand von Instandhaltungskräften oder Wartungstrupps zusammengestellt und an eine Ausgabeeinrichtung auf Basis des Datenkonvoluts übermittelt und angezeigt. Außerdem können zur Vorbereitung der erforderlichen Reparatur- oder Instandhaltungsarbeiten auch entsprechende Aufträge für eine Vergabe von Wartungsaufgaben an Fremdfirmen an die Ausgabeeinrichtung weitergeleitet und dort ausgegeben werden.

In die Datenanalyse 24 ist die Stromnetz-Analyse (GA) 31 miteingeschlossen. Für die Stromnetz-Analyse 31 werden die gewonnenen Daten, die Inhalte wissensbasierter Datenbanken, die Überwachungsberichte, die Statusberichte, das jährliche Audit sowie das Stromnetz-Vermessungsergebnis genutzt.

Auf Basis dieser weiteren oder zusätzlichen bzw. umfassenden Datenquellen wird von der Berechnungseinheit, d. h. dem vorhandenen Computer, eine Stromnetz-Empfehlung einschließlich von Serviceempfehlungen erstellt und an die Ausgabeeinheit übertragen. Des Weiteren werden Aussagen zur Wirtschaftlichkeit bzw. zu den Wirkungsgraden des Stromtransports in dem überwachten Netz miteinbezogen. Anhand der verschiedenen Daten und Datenquellen wird schließlich an die Ausgabeeinrichtung auch eine Stromnetz-Zuverlässigkeit übermittelt und von dieser ausgegeben. Alle vorhandenen Daten, einschließlich der in den Datenbanken vorhandenen wissensbasierten Datenmengen, dienen letztlich der Qualitätsverbesserung des Betreibens der Stromnetze, wobei diese Daten auch für eine effiziente Stromnetz-Planung im Sinne von Stromnetzlast-Vorhersagen Verwendung finden können.

Nach dem Schritt der Datenanalyse 24 folgt der Schritt Definition Meeting (DM) 25, welcher ein Meeting mit dem auftraggebenden Energieversorgungsunternehmen beinhaltet, in welchem die gewonnenen und ausgewerteten Daten dargestellt und digital im von dem Energieversorgungsunternehmen gewünschten Datenformat übergeben werden. Dies schließt eine Datenübertragung in die Softwaresysteme und Rechner des Energieversorgungsunternehmens ein.

Im Schritt Maßnahmepaket (PM) 26 erfolgt eine Festlegung der Wartungs-, Instandhaltungs- bzw. Änderungsmaßnahmen mit entsprechenden Zeitangaben für die geplante Fertigstellung. Die Maßnahme-Empfehlungen werden in dem zu übergebenden Endergebnis festgehalten und basieren auf dem gesamten gewonnenen Datenkonvolut.

Im Schritt Fehlerbehebungsdauer bzw. angestrebtes Zeitziel (RP) 27 werden die durch den Energieversorger auf Basis der ausgewerteten und im Meeting durchgesprochenen Daten analysiert, endgültig festgelegt und Maßnahmen ergriffen, welche zur Behebung von Fehlern bzw. zur Wiederherstellung der Stromführung in den jeweiligen Leitern dienen. Dies stellt eine wichtige Maßnahme zum Feedback vom Energieversorgungsunternehmen an das die Befliegung durchführende Unternehmen dar, wodurch in enger Abstimmung miteinander der Befliegungsaufwand und damit die Kosten für die Instandhaltung optimiert werden können.

Dem schließt sich der Schritt der Ermittlung des Status der Stromnetz-Wartungsaktivitäten (SSNWart) 28 an. Im Rahmen dieses Schrittes erfolgt eine Information des Energieversorgungsunternehmens an das die Befliegung durchführende Unternehmen über den Stand der Wartungs- und Instandhaltungsmaßnahmen sowie über den Bau - und gegebenenfalls vorzunehmenden Umbau - von Stromfreileitungen. Dazu werden die entsprechenden Informationen und die Vorbereitung zur Einpflegung der ausgewerteten Daten aus den Protokollen im Sinne einer aktiven Verfolgung durchzuführender Maßnahmen in das Computersystem an das die Befliegung durchführende Unternehmen übergeben.

Einen weiteren Schritt stellt der Schritt des Status des Überwachungsfluges (SMFI) 29 dar. Anhand der Informationen zu den durchzuführenden Maßnahmen, welche im vorherigen Schritt zwischen dem Energieversorgungsunternehmen und dem die Befliegung durchführenden Unternehmen ausgetauscht worden sind, wird festgelegt, ob erneute Inspektionsflüge anhand der gewonnenen Ergebnisse der vorherigen Abläufe erforderlich sind. Dies stellt eine Nachkontrolle dar und kann gegebenenfalls in einer ergänzenden Inspektionsmaßnahme in Form einer zusätzlichen Befliegung resultieren.

Und schließlich erfolgt im abschließenden Schritt des gesamten durchgeführten Ablaufs der Überwachungs- und Zuverlässigkeitsmanagement-Aufgaben von Stromfreileitungen das Audit 30. Im Rahmen dieses Audits 30 erfolgt eine Auditierung des Energieversorgungsunternehmens auf Basis des gesamten vorangegangenen Prozesses, einschließlich der Vorbereitung und Durchführung von gegebenenfalls vorzunehmenden Wiederholungsbefliegungen bzw. der Inspektion anderer Netzteile, die bei der Erstbefliegung noch nicht berücksichtigt worden sind, für die Gesamtbeurteilung aber wichtig sind. Im Rahmen des Audits erfolgt in einem Meeting der beteiligten verantwortlichen Mitarbeiter, in welchem Änderungen des bestehenden Sicherheits- und Risikomanagements oder dessen Erweiterung oder der Neuimplementierung davon bestimmt werden.

Ein wichtiger Gesichtspunkt ist die permanente Fortführung, Verbesserung oder Erweiterung der Qualifizierung der Mitarbeiter des die Befliegung durchführenden Unternehmens wie auch des Energieversorgers, einschließlich der Instandhaltungstrupps, welche gegebenenfalls von Fremdfirmen gestellt werden, anhand der von der Verarbeitungseinheit des Computersystems berechneten und an die Ausgabeeinheit ausgegebenen Empfehlungen. Seitens des die Befliegung durchführenden Unternehmens werden auf Basis der Auswertung des gesamten Datenkonvoluts Vorschläge zur Anpassung und zur Verbesserung der gesamten Freileitungstechnik sowie einer zusätzlichen Anpassung der Inspektionstechnik empfohlen. Dies hat den Vorteil, dass im Rahmen einer Feedback-Schleife die bestehenden Systeme auf einem automatisierten Wege permanent vervollkommnet werden.

Mit dem erfindungsgemäßen Verfahren und dem erfindungsgemäßen Fluggerät wird neben der gegenüber bekannten Systemen bzw. Verfahren deutlich komplexeren und schnelleren Datenerfassung ein erheblicher Beitrag zur Verringerung schädlicher Einflüsse auf die Umwelt wie beispielsweise Reduzierung von CO₂-Emissionen geleistet.

### Bezugszeichenliste

- 1: Fluggerät / Helikopter / Drehflügler
- 2: Strommast
- 3: Traverse
- 4: Stromleitung
- 5: Isolator
- 6: Erdboden
- 7: Vegetation
- 8: Bebauung
- 9: Mess-/Aufnahmerichtung Kameras
- 10: Mess-/Aufnahmerichtung LIDAR
- 11: Mess-/Aufnahmerichtung UV, IR, RGB, THERMAL, CORONA, Lagesensor
- 12: LIDAR-System, Laserscanner/Laserscansystem
- 13: Kamera
- 14: Sensorik UV, IR, RGB, THERMAL, CORONA, Lagesensor
- 15: Flugrichtung
- 16: Schwenkbereich Sensorik
- 17: Überwachung und Zuverlässigkeitsmanagement von Stromfreileitungen (PliMaRM)
- 18: Stromnetz-Überblick (GOver)
- 19: Stromnetz-Organisation (GOrg)
- 20: Stromnetz-Wartung (GServ)
- 21: Vorbereitung (Prep)
- 22: Überwachung Stromfreileitung (Pline)
- 23: Datenverarbeitung (DP)
- 24: Datenanalyse (DA)
- 25: Definition Meeting (DM)
- 26: Maßnahmepaket (PM)
- 27: Fehlerbehebungsdauer/angestrebtes Zeitziel (RP)
- 28: Status der Stromnetz-Wartungsaktivitäten (SSNWart)
- 29: Status Überwachungsflug (SMFI)
- 30: Audit (A)
- 31: Stromnetz-Analyse (GA)
- 32: Messapparatur
- 33: weitere Sensorik

## Patentansprüche

1. Verfahren zur Überwachung von Betriebszuständen, Leitungsstruktur, Leitungssicherheit und zur Ermittlung von Ausfallwahrscheinlichkeiten von Energiefreileitungssystemen aus der Luft mit einem bemannten Fluggerät (1),
**dadurch gekennzeichnet dass**,
a) das Fluggerät (1) zumindest mit Sensorik (14) für eine Erfassung von physikalische Eigenschaften darstellende Daten der Energiefreileitungssysteme, zumindest mit einer hochauflösenden Digitalkamera (13) für Bilddaten der und um die Energiefreileitungssysteme und mit einem hochauflösenden Laserscansystem (12) für eine Erfassung von Daten zu Umgebungsbedingungen, der Struktur des Geländes und der Leiterstruktur der Energiefreileitungssysteme ausgerüstet wird, welche eine Genauigkeit von bis zu 0,7 cm/Pixel aufweist;
b) die Sensorik (14), die Digitalkamera (13) und das Laserscansystem (12) miteinander und mit Satellitennavigationssystemen, verschieden von GPS, gekoppelt werden und dieselben Daten einer einzelnen Vermessungsantenne nutzen;
c) die erfassten Daten orts- und zeitbezogen einander zugeordnet und miteinander korreliert werden;
d) das Fluggerät (1) auf Basis eines vorgegebenen Flugprofils in Höhe der Energiefreileitung und seitlich von deren Verlaufsrichtung in nur einer einzigen Befliegung des Energiefreileitungssystems alle Daten einschließlich deren Stromschwankungen bei einer gewählten, ein und derselben Fluggeschwindigkeit ermittelt; und
e) die ermittelten Daten hinsichtlich Schäden oder Defekten an den Energiefreileitungssystemen und/oder beginnender Verschlechterung und/oder Beeinflussungen durch Umgebungsbedingungen der Leitungsstruktur auch präventiv ermittelt und einer Verarbeitungseinheit zugeführt werden, in welcher im Sinne eines selbstlernenden Systems auf Basis eines Vergleiches mit in einer darin gespeicherten Datenbank enthaltenen Zuständen notwendige Reparaturen und/oder Instandhaltungsempfehlungen sowie Ausfallwahrscheinlichkeiten für einzelne Elemente, Abschnitte oder Bereiche der Leitungsstruktur unter Einbeziehung von Wachstumsmodellen der Vegetation ermittelt und an eine Ausgabeeinheit ausgegeben werden.

2. Verfahren nach Anspruch 1, **dadurch gekennzeichnet, dass** die Sensorik (14) Temperaturmessungen, insbesondere Ultraviolett- und Infrarot-Messungen, durchführt.

3. Verfahren nach Anspruch 1 oder 2, **dadurch gekennzeichnet, dass** die in der Verarbeitungseinheit ermittelten Reparatur- und/oder Instandhaltungsempfehlungen und/oder Ausfallwahrscheinlichkeiten als Funktion der ermittelten Daten in der Datenbank abgelegt werden und für nachfolgende Vergleiche mitherangezogen werden.

4. Verfahren nach einem der Ansprüche 1 bis 3, **dadurch gekennzeichnet, dass** die hochauflösende Digitalkamera (13) 25 bis 350 Megapixel Mindestauflösung und einen Bildsensor von mindestens 24 x 36 mm oder zumindest einen Mittelformat- oder Vollformatsensor aufweist.

5. Verfahren nach einem der Ansprüche 1 bis 4, **dadurch gekennzeichnet, dass** die hochauflösende Digitalkamera (13) eine harmonierende doppelte mechanische oder elektronische oder mechanisch-elektronisch gekoppelte Bildstabilisierung jeweils in der Kamera und im Objektiv aufweist.

6. Verfahren nach einem der Ansprüche 1 bis 5, **dadurch gekennzeichnet, dass** eine Datenübertragung an eine Bodenstation oder an den Energieversorger als Live-Übertragung mittels Satellitentelefon oder Mobilfunk erfolgt, wobei die Datenübertragung bezüglich erkannter Fehler oder Mängel mit Positionsdaten und Bilddaten verknüpft an den Energieversorger erfolgt und ein Ranking hinsichtlich einer Schwere eines Ereignisses enthält.

7. Verfahren nach einem der Ansprüche 1 bis 6, **dadurch gekennzeichnet, dass** das Laserscansystem (12), die Kameras (13) und die Sensorik (14) mit einer Universalvermessungsantenne gekoppelt werden, mittels welcher die zusammengesetzten Signale des Satellitennavigationssystems empfangen werden, woran sich ein Aufspalten der zusammengesetzten Signale in für einen jeweiligen Verarbeitungsprozess erforderliche Signaldaten anschließt.

8. Verfahren nach einem der Ansprüche 1 bis 7, **dadurch gekennzeichnet, dass** das Laserscansystem (12) die Daten im 360° Vollkreis in der Vertikalen rundum erfasst und damit eine hochauflösende 3D-Abbildung von stromführender Infrastruktur mit einer Genauigkeit im mm-Bereich erzeugt.

9. Verfahren nach einem der Ansprüche 1 bis 8, **dadurch gekennzeichnet, dass** die Bilddaten mit vier Digitalkameras (13) erzeugt werden, welche am Fluggerät (1) so angebracht sind, dass die Bilddaten in Flugrichtung (15) schräg nach vorn und nach hinten und je einmal nach unten in Richtung des Bodens (6) aufgenommen werden.

10. Verfahren nach einem der Ansprüche 1 bis 9, **dadurch gekennzeichnet, dass** das Fluggerät (1) die Datenerfassung für die Überwachung der Betriebszustände der Energiefreileitungssysteme mit einer Fluggeschwindigkeit im Bereich von 0 bis 60 km/h vornimmt.

11. Verfahren nach einem der Ansprüche 1 bis 10, **dadurch gekennzeichnet, dass** das Fluggerät (1) in einem Abstand von 1 m bis 50 m vom Energiefreileitungssystem fliegt.

12. Verfahren nach Anspruch 1, **dadurch gekennzeichnet, dass** das Fluggerät (1) zusätzlich zur Ermittlung von Betriebszuständen und Ausfallwahrscheinlichkeiten ein Radarsystem aufweist, dessen Daten mit denen der Sensorik (14), der Digitalkamera (13), des Laserscansystems (12) und des Satellitennavigationssystems abgestimmt sind.

13. Verfahren nach einem der Ansprüche 1 bis 12, **dadurch gekennzeichnet, dass** mittels einer mit einer Messapparatur (32) verbundenen weiteren Sensorik (33) Störungen im elektromagnetischen Feld bewirkende Fehler und/oder Defekte an den stromführenden Energiefreileitungssystemen gemessen werden, insbesondere mit einem selektiven Strahlungsmessgerät.

14. Verfahren nach Anspruch 13, **dadurch gekennzeichnet, dass** die Fehler und/oder Defekte mit Thermal-, IR-, Corona- oder Tageslichtsensoren gemessen werden.

15. Verfahren nach Anspruch 13 oder 14, **dadurch gekennzeichnet, dass** die Störungen und/oder Defekte als Störungen oder Änderungen im elektromagnetischen Feld mittels Antennen oder Antennenbündel erfasst und aufgezeichnet werden, wobei ein Störsignal von Störungen und/oder Defekten automatisch in horizontaler und/oder vertikaler Richtung verfolgt wird.

16. Fluggerät (1) zur Durchführung des Verfahrens nach einem der Ansprüche 1 bis 15, **dadurch gekennzeichnet, dass** Sensorik (14) für eine Erfassung von Fehlern, Mängeln, Betriebs- und Materialzuständen an Energiefreileitungssystemen, eine Mehrzahl von hochauflösenden Digitalkameras (13) für Bilddaten der Systeme und ein hochauflösendes Laserscansystem (12) am und/oder im Fluggerät (1) vorgesehen sind, wobei die Sensorik (14), die Digitalkamera (13) und das Laserscansystem (12) in Montageeinheiten angebracht sind und eine Datenverarbeitungseinheit im Fluggerät (1) vorgesehen ist.

17. Fluggerät (1) nach Anspruch 16, **dadurch gekennzeichnet, dass** die Sensorik (14) mit Ultraviolett- und Infrarotsensoren und einem Lagesensor, mehreren hochauflösenden Digitalkameras mit einer Mindestauflösung von 25 bis 350 Megapixeln mit Bildstabilisierung von Kamera und Objektiv und einem hochauflösenden Laserscansystem (12) mit 360° Vollkreis in der Vertikalen rundum und mit einer Auflösung im Bereich von ca. 1.500 Pixel/m² eingebaut sind.

18. Fluggerät (1) nach Anspruch 17, **dadurch gekennzeichnet, dass** die Sensorik (14) und das Laserscansystem (12) mit einer Universalvermessungsantenne gekoppelt sind, über welche die zusammengefassten Signale des Satellitennavigationssystems, ausgenommen GPS, empfangbar sind und nach Empfang deren Aufspaltung in für einen jeweiligen Verarbeitungsprozess erforderliche Signaldaten erfolgt.

19. Fluggerät (1) nach einem der Ansprüche 16 bis 18, **dadurch gekennzeichnet, dass** ein zusätzliches Radarsystem eingebaut ist.

20. Fluggerät (1) nach einem der Ansprüche 16 bis 19, **dadurch gekennzeichnet, dass** das Fluggerät (1) ein bemannter Drehflügler ist.

21. Fluggerät (1) nach einem der Ansprüche 16 bis 20, **dadurch gekennzeichnet, dass** eine von einer weiteren Sensorik (33) gespeiste Messapparatur (32) die Fehler, Mängel und/oder Defekte an den stromführenden Energiefreileitungssystemen, welche Störungen im elektromagnetischen Feld bewirken, mittels einer Audioeinrichtung hörbar und mittels eines bildgebenden Elementes sichtbar macht und in einer Verarbeitungseinheit speichert.

## Claims

1. A method for monitoring operating states, line structure, line safety and for determining outage probabilities of overhead power line systems from the air using a manned aircraft (1),
**characterized in that**
a) the aircraft (1) is at least equipped with a sensor system (14) for acquiring data representing physical properties of the overhead power line systems, at least with a high-resolution digital camera (13) for image data of the and around the overhead power line systems, and with a high-resolution laser scanning system (12) for acquiring data on environmental conditions, the structure of the terrain, and the conductor structure of the overhead power line systems, which has an accuracy of up to 0.7 cm/pixel;
b) the sensor system (14), the digital camera (13), and the laser scanning system (12) are coupled to one another and to satellite navigation systems, distinct from GPS, and use the same data of a single measurement antenna;
c) the acquired data are assigned to one another with respect to position and time and are correlated with one another;
d) the aircraft (1) determines all data including its current fluctuations at one selected, uniform flight speed on the basis of a predetermined flight profile at the height of the overhead power line and laterally to its course direction in only one single overflight of the overhead power line system; and
e) the determined data with respect to damage or defects on the overhead power line systems and/or beginning worsening and/or influences by environmental conditions of the line structure are also determined preventively and are supplied to a processing unit, in which required repairs and/or maintenance recommendations and outage probabilities for individual elements, sections, or areas of the line structure with incorporation of growth models of the vegetation are determined in terms of a self-learning system on the basis of a comparison to states contained in a database stored therein and are output at an output unit.

2. The method as claimed in claim 1, **characterized in that** the sensor system (14) carries out temperature measurements, in particular ultraviolet and infrared measurements.

3. The method as claimed in claim 1 or 2, **characterized in that** the repair and/or maintenance recommendations and/or outage probabilities determined in the processing unit are stored as a function of the determined data in the database and also used for following comparisons.

4. The method as claimed in any one of claims 1 to 3, **characterized in that** the high-resolution digital camera (13) has a minimum resolution of 25 to 350 megapixels and an image sensor of at least 24 x 36 mm or at least a medium-format or full-format sensor.

5. The method as claimed in any one of claims 1 to 4, **characterized in that** the high-resolution digital camera (13) has a harmonizing double mechanical or electrical or mechanical-electronic coupled image stabilization in each case in the camera and in the lens.

6. The method as claimed in any one of claims 1 to 5, **characterized in that** a data transmission takes place to a ground station or to the energy supplier as a live transmission by means of satellite telephone or mobile radio, wherein the data transmission with respect to recognized faults or deficiencies takes place linked with position data and image data to the energy supplier and contains a ranking with respect to a severity of an event.

7. The method as claimed in any one of claims 1 to 6, **characterized in that** the laser scanning system (12), the cameras (13), and the sensor system (14) are coupled to a universal measurement antenna, by means of which the combined signals of the satellite navigation system are received, which is followed by splitting of the combined signals into signal data required for a respective processing process.

8. The method as claimed in any one of claims 1 to 7, **characterized in that** the laser scanning system (12) acquires the data in the 360° full circle all around in the vertical and thus generates a high-resolution 3D depiction of current-carrying infrastructure having an accuracy in the millimeter range.

9. The method as claimed in any one of claims 1 to 8, **characterized in that** the image data are generated using for digital cameras (13), which are attached on the aircraft (1) so that the image data are recorded diagonally to the front and to the rear in the flight direction (15) and once in each case downward in the direction of the ground (6).

10. The method as claimed in any one of claims 1 to 9, **characterized in that** the aircraft (1) performs the data acquisition for monitoring the operating states of the overhead power line systems at a flight speed in the range of 0 to 60 km/h.

11. The method as claimed in any one of claims 1 to 10, **characterized in that** the aircraft (1) flies at a distance of 1 to 50 m from the overhead power line system.

12. The method as claimed in claim 1, **characterized in that** the aircraft (1) additionally has a radar system for determining operating states and outage probabilities, the data of which are matched with those of the sensor system (14), the digital camera (13), the laser scanning system (12), and the satellite navigation system.

13. The method as claimed in any one of claims 1 to 12, **characterized in that** faults and/or defects on the current-carrying overhead power line systems causing disturbances in the electromagnetic field are measured by means of a further sensor system (33) connected to a measuring apparatus (32), in particular using a selective radiation meter.

14. The method as claimed in claim 13, **characterized in that** the faults and/or defects are measured using thermal, IR, corona, or daylight sensors.

15. The method as claimed in claim 13 or 14, **characterized in that** the disturbances and/or defects are acquired as disturbances or changes in the electromagnetic field by means of antennas or antenna bundles and recorded, wherein a disturbance signal of disturbances and/or defects is tracked automatically in the horizontal and/or vertical direction.

16. An aircraft (1) for carrying out the method as claimed in any one of claims 1 to 15, **characterized in that** a sensor system (14) for acquiring faults, deficiencies, operating states, and material states on overhead power line systems, a plurality of high-resolution digital cameras (13) for image data of the systems, and a high-resolution laser scanning system (12) are provided on and/or in the aircraft (1), wherein the sensor system (14), the digital camera (13), and the laser scanning system (12) are attached in mounting units and a data processing unit is provided in the aircraft (1).

17. The aircraft (1) as claimed in claim 16, **characterized in that** the sensor system (14) is installed having ultraviolet and infrared sensors and a position sensor, multiple high-resolution digital cameras having a minimum resolution of 25 to 350 megapixels having image stabilization of camera and lens, and a high-resolution laser scanning system (12) having 360° full circle all around in the vertical and having a resolution in the range of approximately 1500 pixels/m².

18. The aircraft (1) as claimed in claim 17, **characterized in that** the sensor system (14) and the laser scanning system (12) are coupled to a universal measurement antenna, via which the combined signals of the satellite navigation system, except for GPS, are receivable and, after reception, the splitting thereof takes place into signal data required for a respective processing process.

19. The aircraft (1) as claimed in any one of claims 16 to 18, **characterized in that** an additional radar system is installed.

20. The aircraft (1) as claimed in any one of claims 16 to 19, **characterized in that** the aircraft (1) is a manned rotary wing aircraft.

21. The aircraft (1) as claimed in any one of claims 16 to 20, **characterized in that** a measuring apparatus (32) fed by a further sensor system (33) makes the faults, deficiencies, and/or defects on the current-carrying overhead power line systems, which cause disturbances in the electromagnetic field, audible by means of an audio device and visible by means of an imaging element and stores them in a processing unit.

## Revendications

1. Procédé de surveillance d'états opérationnels, d'une structure de lignes, de la sécurité de lignes et de détermination de probabilités de panne de systèmes de lignes aériennes d'énergie depuis l'air avec un engin volant (1) habité, **caractérisé en ce que**
a) l'engin volant (1) est équipé au moins d'un ensemble de capteurs (14) pour une acquisition de données représentant des propriétés physiques des systèmes de lignes aériennes d'énergie, au moins d'une caméra numérique (13) à haute résolution pour des données d'image des systèmes de lignes aériennes d'énergie et autour de ceux-ci et d'un système de balayage laser (12) à haute résolution pour une acquisition de données à propos des conditions environnantes, de la structure du terrain et de la structure de conducteurs des systèmes de lignes aériennes d'énergie, lequel présente une précision pouvant atteindre 0,7 cm/pixel ;
b) l'ensemble de capteurs (14), la caméra numérique (13) et le système de balayage laser (12) sont couplés entre eux et avec des systèmes de navigation par satellite, différents du GPS, et utilisent les mêmes données d'une unique antenne de mesurage ;
c) les données acquises étant associées les unes aux autres en référence au lieu et au moment et étant corrélées entre elles ;
d) l'engin volant (1) détermine toutes les données, y compris leurs fluctuations de courant avec une seule et même vitesse de vol choisie, sur la base d'un profil de vol prédéfini à hauteur de la ligne aérienne d'énergie et latéralement à sa direction de tracé en un seul survol du système de ligne aérienne d'énergie ; et
e) les données déterminées sont également déterminées de manière préventive du point de vue des dommages ou des défauts aux systèmes de lignes aériennes d'énergie et/ou d'un début de dégradation et/ou d'influences par les conditions environnementales de la structure de lignes et acheminées à une unité de traitement, dans laquelle sont déterminées et délivrées au niveau d'une unité de sortie les réparations nécessaires et/ou les recommandations d'entretien ainsi que les probabilités de panne pour les éléments, portions ou zones individuels de la structure de lignes en impliquant des modèles de croissance de la végétation, dans le sens d'un système à auto-apprentissage sur la base d'une comparaison avec des états contenus dans une base de données qui y est enregistrée.

2. Procédé selon la revendication 1, **caractérisé en ce que** l'ensemble de capteurs (14) effectue des mesures de température, notamment des mesures aux ultraviolets et aux infrarouges.

3. Procédé selon la revendication 1 ou 2, **caractérisé en ce que** les recommandations de réparation et/ou d'entretien et/ou les probabilités de panne déterminées dans l'unité de traitement sont déposées dans la base de données en tant que fonctions des données déterminées et consultées conjointement pour les comparaisons suivantes.

4. Procédé selon l'une des revendications 1 à 3, **caractérisé en ce que** la caméra numérique (13) à haute résolution présente une résolution minimale de 25 à 350 mégapixels et un capteur d'images d'au moins 24 x 36 mm ou au moins un capteur à moyen format ou à plein format.

5. Procédé selon l'une des revendications 1 à 4, **caractérisé en ce que** la caméra numérique (13) à haute résolution possède, respectivement dans la caméra et dans l'objectif, une stabilisation d'image mécanique ou électronique doublée harmonisante ou couplée de manière mécano-électronique.

6. Procédé selon l'une des revendications 1 à 5, **caractérisé en ce qu'**une transmission de données à une station au sol ou au fournisseur d'énergie s'effectue sous la forme d'une transmission en direct au moyen d'un téléphone par satellite ou de la radiocommunication mobile, la transmission de données concernant les erreurs ou les lacunes reconnues s'effectuant de manière liée avec des données de position et des données d'image au fournisseur d'énergie et contenant une classification du point de vue de la gravité de l'événement.

7. Procédé selon l'une des revendications 1 à 6, **caractérisé en ce que** le système de balayage laser (12), les caméras (13) et l'ensemble de capteurs (14) sont couplés avec une antenne de mesurage universelle au moyen de laquelle sont reçus les signaux composés du système de navigation par satellite, suivi d'un fractionnement des signaux composés en données de signal nécessaires pour un processus de traitement respectif.

8. Procédé selon l'une des revendications 1 à 7, **caractérisé en ce que** le système de balayage laser (12) acquiert les données dans un cercle complet de 360° tout autour de la verticale et génère avec celles-ci une représentation 3D à haute résolution de l'infrastructure conductrice d'électricité avec une précision de l'ordre du mm.

9. Procédé selon l'une des revendications 1 à 8, **caractérisé en ce que** les données d'image sont générées avec quatre caméras numériques (13), lesquelles sont montées sur l'engin volant (1) de telle sorte que les données d'image sont enregistrées dans la direction du vol (15) obliquement vers l'avant et vers l'arrière et respectivement une fois vers le bas en direction du sol (6).

10. Procédé selon l'une des revendications 1 à 9, **caractérisé en ce que** l'engin volant (1) réalise l'acquisition de données pour la surveillance des états opérationnels des systèmes de lignes aériennes d'énergie avec une vitesse de vol dans la plage de 0 à 60 km/h.

11. Procédé selon l'une des revendications 1 à 10, **caractérisé en ce que** l'engin volant (1) vole à une distance de 1 m à 50 m du système de lignes aériennes d'énergie.

12. Procédé selon la revendication 1, **caractérisé en ce que** l'engin volant (1), possède en plus un radar pour la détermination des états opérationnels et des probabilités de panne, dont les données sont accordées avec celles de l'ensemble de capteurs (14), de la caméra numérique (13), du système de balayage laser (12) et du système de navigation par satellite.

13. Procédé selon l'une des revendications 1 à 12, **caractérisé en ce que** des erreurs et/ou des défauts au niveau des systèmes de lignes aériennes d'énergie conducteurs d'électricité, qui provoquent des perturbations dans le champ électromagnétique, sont mesurés avec un ensemble de capteurs supplémentaire (33) relié à un appareil de mesure (32), notamment avec un appareil de mesure de rayonnements sélectif.

14. Procédé selon la revendication 13, **caractérisé en ce que** les erreurs et/ou les défauts sont mesurés avec des capteurs thermiques, d'IR, d'effet corona ou de lumière du jour.

15. Procédé selon la revendication 13 ou 14, **caractérisé en ce que** les perturbations et/ou les défauts sont détectés sous la forme de perturbations ou de modifications dans le champ électromagnétique au moyen d'antenne ou de faisceaux d'antennes et enregistrés, un signal de perturbation de perturbations et/ou de défauts étant suivi automatiquement dans la direction horizontale et/ou verticale.

16. Engin volant (1) destiné à mettre en oeuvre le procédé selon l'une des revendications 1 à 15, **caractérisé en ce qu'**un ensemble de capteurs (14) pour une détection d'erreurs, de lacunes, d'états opérationnels et de matériel au niveau de systèmes de lignes aériennes d'énergie, une pluralité de caméras numériques (13) à haute résolution pour des données d'image des systèmes et un système de balayage laser (12) à haute résolution sont présents sur et/ou dans l'engin volant (1), l'ensemble de capteurs (14), la caméra numérique (13) et le système de balayage laser (12) étant montés dans des unités de montage et une unité de traitement de données étant présente dans l'engin volant (1).

17. Engin volant (1) selon la revendication 16, **caractérisé en ce que** l'ensemble de capteurs (14) sont incorporés avec des capteurs d'ultraviolets et d'infrarouges et un détecteur de position, plusieurs caméras numériques à haute résolution ayant une résolution minimale de 25 à 350 mégapixels avec stabilisation d'image de la caméra et de l'objectif et un système de balayage laser (12) à haute résolution avec un cercle complet de 360° tout autour de la verticale et avec une résolution de l'ordre d'environ 1 500 pixels/m².

18. Engin volant (1) selon la revendication 17, **caractérisé en ce que** l'ensemble de capteurs (14) et le système de balayage laser (12) sont couplés avec une antenne de mesurage universelle, par le biais de laquelle peuvent être reçus les signaux composés du système de navigation par satellite, à l'exception du GPS, et, après la réception, s'effectue leur fractionnement en données de signal nécessaires pour un processus de traitement respectif.

19. Engin volant (1) selon l'une des revendications 16 à 18, **caractérisé en ce qu'**un système radar supplémentaire est installé.

20. Engin volant (1) selon l'une des revendications 16 à 19, **caractérisé en ce que** l'engin volant (1) et un giravion.

21. Engin volant (1) selon l'une des revendications 16 à 20, **caractérisé en ce qu'**un appareil de mesure (32), alimenté par un ensemble de capteurs supplémentaire (33), rend audibles au moyen d'un dispositif audio et rend visibles au moyen d'un élément de production d'image, les erreurs, lacunes et/ou défauts au niveau des systèmes de lignes aériennes d'énergie, lesquels provoquent des perturbations dans le champ électromagnétique, et les mémorise dans une unité de traitement.
